# EUROPEAN PATENT SPECIFICATION

(11) **EP 2 562 814 B1**
(45) Date of publication and mention of the grant of the patent: **19.08.2020**
(21) Application number: 12151048.1
(22) Date of filing: 13.01.2012
(51) Int. Cl.: H01L 27/15, H01L 33/00, H01L 33/62, H01L 33/32, H01L 33/22, H01L 33/38

(54) **Light emitting device and light emitting device package**
Lichtemittierende Vorrichtung und lichtemittierende Vorrichtungsverpackung
Dispositif électroluminescent et emballage de dispositif électroluminescent

(30) Priority: 22.08.2011 KR 20110083722; 04.11.2011 KR 20110114385
(43) Date of publication of application: 27.02.2013
(73) Proprietor: LG Innotek Co., Ltd., Seoul, 04637 (KR)
(72) Inventor: Jeong, Hwan Hee, 100-714 Seoul (KR)
(74) Representative: Plasseraud IP

(56) References cited:
- EP-A1- 2 375 460
- EP-A2- 2 355 189
- WO-A2-2010/114250
- KR-B1- 101 039 879
- US-A1- 2010 155 746

## Description

### BACKGROUND

The embodiment relates to a light emitting device, a light emitting device package and a light unit.

LEDs (light emitting diodes) have been extensively used as light emitting devices. The LEDs convert electric signals into light, such as infrared ray, visible ray or ultraviolet ray, by using the characteristics of compound semiconductors.

As the light efficiency of the light emitting device has become increased, the light emitting device has been applied in various fields, such as display devices and lighting devices.

Document WO 2010/114250 A2 relates to a light emitting device comprising a plurality of light emitting cells. Adjacent light emitting cells are electrically connected with each other in series through the contact parts, with an additional insulating layer bieng provided between the first and second light emitting cells and with an etching process for an insulating layer being required to form the contact part.

Document US 2010/155746 relates to a monolithic LED chip comprising a plurality of junctions mounted on a submount.

Document KR 101 039 879 relates to a light emitting device with a junction layer.

Document EP 2 355 189 relates to a light emitting device with an insulating layer for covering an outer peripheral surface of an electrode.

### SUMMARY

The embodiment provides a light emitting device capable of improving process stability and comprising a plurality of cells electrically connected with each other, a light emitting device package and a light unit.

According to the embodiment, there is provided a light emitting device as claimed in the current set of claims.

These and other advantageous technical features in accordance with the present invention are set out in the appended claims.

According to the embodiment, there is provided a light emitting device package comprising a body, a light emitting device according to one of the appended claims, which is installed on the body, and first and second lead electrodes electrically connected to the light emitting device.

According to the embodiment, there is provided a light unit comprising a board, a light emitting device according to one of the appended claims, which is installed on the board, and an optical member passing through a light supplied from the light emitting device.

As described above, the embodiment provides a light emitting device capable of improving process stability and comprising a plurality of cells electrically connected with each other, a light emitting device package and a light unit.

### BRIEF DESCRIPTION OF THE DRAWINGS

FIG. 1 is a sectional view showing a light emitting device according to the embodiment;
FIGS. 2 to 6 are sectional views showing a method for manufacturing the light emitting device according to the embodiment;
FIGS. 7 and 8 are sectional views showing modified examples of a light emitting device according to the embodiment;
FIG. 9 is a sectional view showing a light emitting device according to another embodiment;
FIGS. 10 to 15 are sectional views showing a method for manufacturing the light emitting device according to another embodiment;
FIGS. 16 and 18 are sectional views showing modified examples of a light emitting device according to another embodiment;
FIG. 19 is a view showing a light emitting device package according to the embodiment;
FIG. 20 is a view showing a display device according to the embodiment;
FIG. 21 is a view showing a display device according to another embodiment; and
FIG. 22 is a view showing a lighting device according to the embodiment.

### DETAILED DESCRIPTION OF THE EMBODIMENTS

In the description of the embodiments, it will be understood that when a layer (or film), a region, a pattern, or a structure is referred to as being "on" or "under" another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, a light emitting device, a light emitting device package, a light unit and a method for manufacturing the light emitting device according to the embodiments will be described with reference to accompanying drawings.

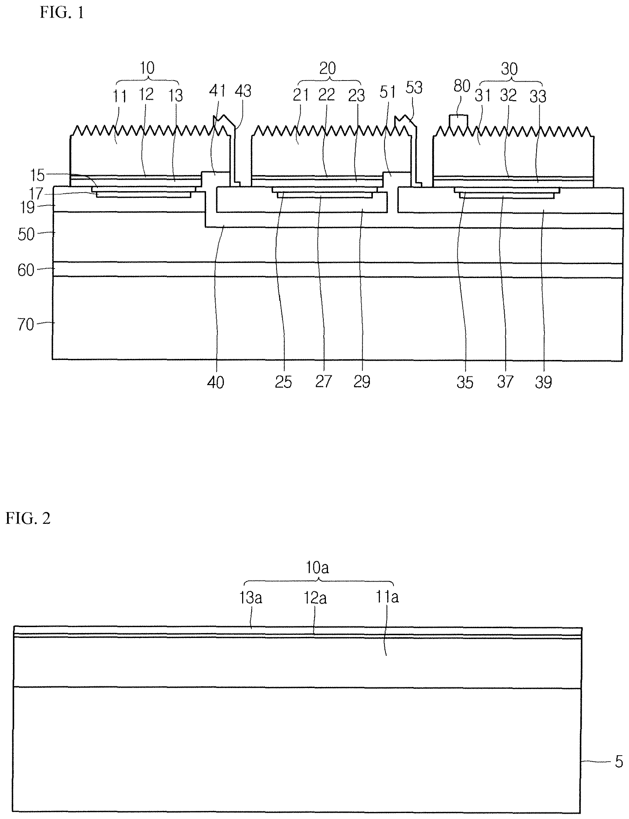

FIG. 1 is a view showing the light emitting device according to the embodiment.

As shown in FIG. 1, the light emitting device according to the embodiment comprises a first light emitting structure 10, a second light emitting structure 20, and may comprise a third light emitting structure 30, a first reflective electrode 17, a second reflective electrode 27, a third reflective electrode 37 and an electrode 80. Although three light emitting structures are shown in FIG. 1, the light emitting device according to the embodiment may comprise two light emitting structures or at least four light emitting structures. The light emitting structures may be electrically connected with each other. The light emitting structures may be electrically connected with each other in series. The first and second light emitting structures 10 and 20 are electrically connected to each other by a first contact part 43. The second and third light emitting structures 20 and 30 may be electrically connected to each other by a second contact part 53. In addition, the light emitting structures may be disposed on a support substrate 70.

The first light emitting structure 10 comprises a first conductive type first semiconductor layer 11, a first active layer 12 and a second conductive type second semiconductor layer 13. The first active layer 12 is disposed between the first conductive type first semiconductor layer 11 and the second conductive type second semiconductor layer 13. The first active layer 12 is disposed under the first conductive type first semiconductor layer 11 and the second conductive type second semiconductor layer 13 is disposed under the first active layer 12.

For instance, the first conductive type first semiconductor layer 11 may be prepared as an n type semiconductor layer doped with an n type dopant as a first conductive type dopant, and the second conductive type second semiconductor layer 13 may be prepared as a p type semiconductor layer doped with a p type dopant as a second conductive type dopant. In contrast, the first conductive type first semiconductor layer 11 may be prepared as the p type semiconductor layer and the second conductive type second semiconductor layer 13 may be prepared as an n type semiconductor layer.

For instance, the first conductive type first semiconductor layer 11 may comprise an n type semiconductor layer. The first conductive type first semiconductor layer 11 may be prepared by using a semiconductor material having a compositional formula of lnₓAl_{y}Ga_{1-x-y}N (0≤x≤1, 0≤y≤1, and 0≤x+y≤1). For instance, the first conductive type first semiconductor layer 11 may comprise one selected from the group consisting of GaN, AIN, AIGaN, InGaN, InN, InAIGaN, AlInN, AIGaAs, GaP, GaAs, GaAsP, and AlGalnP and may be doped with the n type dopant, such as Si, Ge, Sn, Se, or Te.

The first active layer 12 emits the light based on the band gap difference of the energy band according to a material constituting the first active layer 12 through the recombination of electrons (or holes) injected through the first conductive type first semiconductor layer 11 and holes (or electrons) injected through the second conductive type second semiconductor layer 13. The first active layer 12 may have one of a single quantum well structure, a multiple quantum well (MQW) structure, a quantum dot structure, and a quantum wire structure, but the embodiment is not limited thereto.

The first active layer 12 may comprise a semiconductor material having a compositional formula of lnₓAl_{y}Ga_{1-x-y}N (0≤x≤1, 0≤y≤1, and 0≤x+y≤1). If the first active layer 12 has the MQW structure, the first active layer 12 may have a stack structure of a plurality of well layers and a plurality of barrier layers. For example, the first active layer 12 may comprise a stack structure of InGaN well/GaN barrier layers.

For instance, the second conductive type second semiconductor layer 13 may comprise a p type semiconductor layer. The second conductive type second semiconductor layer 13 may be prepared by using a semiconductor material having a compositional formula of lnₓAl_{y}Ga_{1-x-y}N (0≤x≤1, 0≤y≤1, and 0≤x+y≤1). For instance, the second conductive type second semiconductor layer 13 may comprise one selected from the group consisting of GaN, AIN, AIGaN, InGaN, InN, InAIGaN, AlInN, AIGaAs, GaP, GaAs, GaAsP, and AlGalnP and may be doped with the p type dopant, such as Mg, Zn, Ca, Sr, or Ba.

Meanwhile, the first conductive type first semiconductor layer 11 may comprise a p type semiconductor layer, and the second conductive type second semiconductor layer 13 may comprise an n type semiconductor layer. In addition, a semiconductor layer comprising an n type semiconductor layer or a p type semiconductor layer may be additionally formed under the second conductive type second semiconductor layer 13. Accordingly, the first light emitting structure 10 may have at least one of NP, PN, NPN, and PNP junction structures. In addition, the doping concentration of impurities in the first conductive type first semiconductor layers 11 and the second conductive type second semiconductor layer 13 may be uniform or non-uniform. In other words, the light emitting structure 10 may be variously formed, but the embodiment is not limited thereto.

In addition, a first conductive type InGaN/GaN superlattice structure or a first conductive type lnGaN/lnGaN superlattice structure may be formed between the first conductive type first semiconductor layers 11 and the first active layer 12. In addition, a second conductive type AIGaN layer may be formed between the second conductive type second semiconductor layers 13 and the first active layer 12.

In addition, the second light emitting structure 20 comprises a first conductive type third semiconductor layer 21, a second active layer 22 and a second conductive type fourth semiconductor layer 23. The second active layer 22 is disposed between the first conductive type third semiconductor layer 21 and the second conductive type fourth semiconductor layer 23. The second active layer 22 is disposed under the first conductive type third semiconductor layer 21 and the second conductive type fourth semiconductor layer 23 is disposed under the second active layer 22. The second light emitting structure 20 may be prepared similarly to the first light emitting structure 10 described above.

Further, the third light emitting structure 30 may comprise a first conductive type fifth semiconductor layer 31, a third active layer 32 and a second conductive type sixth semiconductor layer 33. The third active layer 32 may be disposed between the first conductive type fifth semiconductor layer 31 and the second conductive type sixth semiconductor layer 33. The third active layer 32 may be disposed under the first conductive type fifth semiconductor layer 31 and the second conductive type sixth semiconductor layer 33 may be disposed under the third active layer 32. The third light emitting structure 30 may be prepared similarly to the first light emitting structure 10 described above.

A first ohmic contact layer 15 and a first reflective electrode 17 may be disposed under the first light emitting structure 10. A first metal layer 19 is disposed under the first light emitting structure 10 and around the first reflective electrode 17. The first metal layer 19 may be disposed around the first ohmic contact layer 15 and under the first reflective electrode 17.

For instance, the first ohmic contact layer 15 may comprise a transparent conductive oxide layer. In detail, the first ohmic contact layer 15 may comprise at least one selected from the group consisting of ITO (Indium Tin Oxide), IZO (Indium Zinc Oxide), AZO (Aluminum Zinc Oxide), AGZO (Aluminum Gallium Zinc Oxide), IZTO (Indium Zinc Tin Oxide), IAZO (Indium Aluminum Zinc Oxide), IGZO (Indium Gallium Zinc Oxide), IGTO (Indium Gallium Tin Oxide), ATO (Antimony Tin Oxide), GZO (Gallium Zinc Oxide), IZON (IZO Nitride), ZnO, IrOx, RuOx, NiO, Pt, and Ag.

The first reflective electrode 17 may comprise a metallic material having high reflectivity. For instance, the first reflective electrode 17 may comprise a metal or an alloy comprising at least one selected from the group consisting of Ag, Ni, Al, Rh, Pd, Ir, Ru, Mg, Zn, Pt, Au, and Hf. In addition, the first reflective electrode 17 may be formed in a multiple structure by using the metal or the alloy and transmissive conductive material such as ITO, IZO, IZTO, IAZO, IGZO, IGTO, AZO or ATO. For example, according to the embodiment, the first reflective electrode 17 may comprise at least one of Ag, Al, an Ag-Pd-Cu alloy and an Ag-Cu alloy.

The first ohmic contact layer 15 makes ohmic-contact with the first light emitting structure 10. In addition, the first reflective electrode 17 may increase quantity of light extracted to the outside by reflecting the light incident from the first light emitting structure 10.

When a bonding layer 60 is formed, the first metal layer 19 may prevent materials included in the bonding layer 60 from diffusing toward the first reflective electrode 17. In detail, the first metal layer 19 may prevent the materials, such as Sn, included in the bonding layer 60 from exerting an influence on the first reflective electrode 17. The first metal layer 19 may comprise at least one of Cu, Ni, Ti-W, W, Pt, V, Fe, Mo, Ti and Cr. The first metal layer 19 may comprise a transparent conductive oxide layer. The first metal layer 19 may be referred to as an isolation layer or a channel layer.

In addition, a second ohmic contact layer 25 and a second reflective electrode 27 may be disposed under the second light emitting structure 20. A second metal layer 29 is disposed under the second light emitting structure 20 and around the second reflective electrode 27. The second metal layer 29 may be disposed around the second ohmic contact layer 25 and under the second reflective electrode 27.

For instance, the second ohmic contact layer 25 may comprise a transparent conductive oxide layer. In detail, the second ohmic contact layer 25 may comprise at least one selected from the group consisting of ITO, IZO, AZO, AGZO, IZTO, IAZO, IGZO, IGTO, ATO, GZO, IZON, ZnO, IrOx, RuOx, NiO, Pt, and Ag.

The second reflective electrode 27 may comprise a metallic material having high reflectivity. For instance, the second reflective electrode 27 may comprise a metal or an alloy comprising at least one selected from the group consisting of Ag, Ni, Al, Rh, Pd, Ir, Ru, Mg, Zn, Pt, Au, and Hf. In addition, the second reflective electrode 27 may be formed in a multiple structure by using the metal or the alloy and transmissive conductive material such as ITO, IZO, IZTO, IAZO, IGZO, IGTO, AZO or ATO. For example, according to the embodiment, the second reflective electrode 27 may comprise at least one of Ag, Al, an Ag-Pd-Cu alloy and an Ag-Cu alloy.

The second ohmic contact layer 25 makes ohmic-contact with the second light emitting structure 20. In addition, the second reflective electrode 27 may increase quantity of light extracted to the outside by reflecting the light incident from the second light emitting structure 20.

When the bonding layer 60 is formed, the second metal layer 29 may prevent materials included in the bonding layer 60 from diffusing toward the second reflective electrode 27. In detail, the second metal layer 29 may prevent the materials included in the bonding layer 60, such as Sn, from exerting an influence upon the second reflective electrode 27. The second metal layer 29 may comprise at least one of Cu, Ni, Ti-W, W, Pt, V, Fe, Mo, Ti and Cr. The second metal layer 29 may comprise a transparent conductive oxide layer.

In addition, a third ohmic contact layer 35 and a third reflective electrode 37 may be disposed under the third light emitting structure 30. A third metal layer 39 may be disposed under the third light emitting structure 30 and around the third reflective electrode 37. The third metal layer 39 may be disposed around the third ohmic contact layer 35 and under the third reflective electrode 37.

For instance, the third ohmic contact layer 35 may comprise a transparent conductive oxide layer. In detail, the third ohmic contact layer 35 may comprise at least one selected from the group consisting of ITO, IZO, AZO, AGZO, IZTO, IAZO, IGZO, IGTO, ATO, GZO, IZON, ZnO, IrOx, RuOx, NiO, Pt, and Ag.

The third reflective electrode 37 may comprise a metallic material having high reflectivity. For instance, the third reflective electrode 37 may comprise a metal or an alloy comprising at least one selected from the group consisting of Ag, Ni, Al, Rh, Pd, Ir, Ru, Mg, Zn, Pt, Au, and Hf. In addition, the third reflective electrode 37 may be formed in a multiple structure by using the metal or the alloy and transmissive conductive material such as ITO, IZO, IZTO, IAZO, IGZO, IGTO, AZO or ATO. For example, according to the embodiment, the second reflective electrode 37 may comprise at least one of Ag, Al, an Ag-Pd-Cu alloy and an Ag-Cu alloy.

The third ohmic contact layer 35 makes ohmic-contact with the third light emitting structure 30. In addition, the third reflective electrode 37 may increase quantity of light extracted to the outside by reflecting the light incident from the third light emitting structure 30.

When the bonding layer 60 is formed, the third metal layer 39 may prevent materials included in the bonding layer 60 from diffusing toward the third reflective electrode 37. In detail, the third metal layer 39 may prevent the materials, such as Sn, included in the bonding layer 60 from exerting an influence upon the third reflective electrode 37. The third metal layer 39 may comprise at least one of Cu, Ni, Ti-W, W, Pt, V, Fe, Mo, Ti, and Cr.

The first contact part 43 may be disposed between the first light emitting structure 10 and the second light emitting structure 20. The first contact part 43 makes direct contact with a top surface of the first conductive type first semiconductor layer 11. The first contact part 43 makes direct contact with a lateral side of the first conductive type first semiconductor layer 11. The first contact part 43 makes contact with the second metal layer 29. The first contact part 43 makes direct contact with the top surface of the second metal layer 29. Since the second metal layer 29 is electrically connected to the second reflective electrode 27 and the second ohmic contact layer 25, the first contact part 43 may be electrically connected to the second conductive type fourth semiconductor layer 23. Therefore, the first conductive type first semiconductor layer 11 may be electrically connected to the second conductive type fourth semiconductor layer 23 through the first contact part 43.

For instance, the first contact part 43 may comprise at least one selected from the group consisting of Cr, Al, Ti, Ni, Pt, V, and Ag. In addition, the first contact part 43 may comprise a transparent conductive oxide layer. In detail, the first contact part 43 may comprise at least one selected from the group consisting of ITO, IZO, AZO, AGZO, IZTO, IAZO, IGZO, IGTO, ATO, GZO, IZON, ZnO, IrOx, RuOx, and NiO.

The first contact part 43 makes direct contact with the top surface of the first conductive type first semiconductor layer 11. For instance, the first conductive type first semiconductor layer 11 may comprise a GaN layer. When taking the growing direction and etching direction of the semiconductor layer into consideration, the first contact part 43 makes contact with an N face of the first conductive type first semiconductor layer 11.

The first insulating layer 41 is disposed between the first contact part 43 and the second conductive type second semiconductor layer 13. The first insulating layer 41 is disposed between the first contact part 43 and the first active layer 12. The first insulating layer 41 may be disposed at a lower portion of the first conductive type first semiconductor layer 11. The first insulating layer 41 may make contact with the first contact part 43. The lateral side of the first insulating layer 41 may make contact with the first contact part 43. The first insulating layer 41 may comprise a transmissive material or an insulating material. For instance, the first insulating layer 41 may comprise SiO₂, SiOₓ, SiOₓN_{y}, Si₃N₄, Al₂O₃, TiO₂, or AIN.

The second contact part 53 may be disposed between the second and third light emitting structures 20 and 30. The second contact part 53 may make contact with the top surface of the first conductive type third semiconductor layer 21. The second contact part 53 may make contact with the lateral side of the first conductive type third semiconductor layer 21. The second contact part 53 may make contact with the third metal layer 39. The second contact part 53 may make contact with the top surface of the third metal layer 39. Since the third metal layer 39 is electrically connected to the third reflective electrode 37 and the third ohmic contact layer 35, the second contact part 53 may be electrically connected to the second conductive type sixth semiconductor layer 33. Therefore, the first conductive type third semiconductor layer 21 may be electrically connected to the second conductive type sixth semiconductor layer 33 through the second contact part 53.

For instance, the second contact part 53 may comprise at least one selected from the group consisting of Cr, Al, Ti, Ni, Pt, V, and Ag. In addition, the second contact part 53 may comprise a transparent conductive oxide layer. In detail, the second contact part 53 may comprise at least one selected from the group consisting of ITO, IZO, AZO, AGZO, IZTO, IAZO, IGZO, IGTO, ATO, GZO, IZON, ZnO, IrOx, RuOx, and NiO.

The second contact part 53 may make contact with the top surface of the first conductive type third semiconductor layer 21. For instance, the first conductive type third semiconductor layer 21 may comprise a GaN layer. In this case, when taking the growing direction and etching direction of the semiconductor layer into consideration, the first contact part 53 may make contact with an N face of the first conductive type third semiconductor layer 21.

A second insulating layer 51 may be disposed between the second contact part 53 and the second conductive type fourth semiconductor layer 23. The second insulating layer 51 may be disposed between the second contact part 53 and the second active layer 22. The second insulating layer 51 may be disposed at a lower portion of the first conductive type third semiconductor layer 21. The second insulating layer 51 may make contact with the second contact part 53. The lateral side of the second insulating layer 51 may make contact with the second contact part 53. The second insulating layer 51 may comprise a transmissive material, or an insulating material. The second insulating layer 51 may comprise a material such as SiO₂, SiOₓ, SiOₓN_{y}, Si₃N₄, Al₂O₃, TiO₂, or AIN.

A third insulating layer 40 may be disposed between the second metal layer 29 and the third metal layer 39. The third insulating layer 40 may comprise an oxide or a nitride. The third insulating layer 40 may comprise a transmissive and insulating material such as SiO₂, SiOₓ, SiOₓN_{y}, Si₃N₄, and Al₂O₃. In addition, the third insulating layer 40 may make contact with the lower portion of the first insulating layer 41. In addition, the third insulating layer 40 may make contact with the lower portion of the second insulating layer 51. A first region of the third insulating layer 40 may be disposed between the first metal layer 19 and the second metal layer 29. The second region of the third insulating layer 40 may be disposed between the second metal layer 29 and the third metal layer 39.

A diffusion barrier layer 50, the bonding layer 60, and a support member 70 may be disposed under the first metal layer 19 and the third insulating layer 40.

When the bonding layer 60 is formed, the diffusion barrier layer 50 may prevent materials included in the bonding layer 60 from diffusing toward the first to third reflective electrodes 17, 27 and 37. In detail, the diffusion barrier layer 50 may prevent the materials, such as Sn, included in the bonding layer 60 from exerting an influence upon the first to third reflective electrodes 17, 27 and 37. The diffusion barrier layer 50 may comprise at least one of Cu, Ni, Ti-W, W, Pt, V, Fe, and Mo.

The bonding layer 60 may comprise a barrier metal or a bonding metal. For instance, the bonding layer 60 may comprise at least one of Ti, Au, Sn, Ni, Cr, Ga, In, Bi, Cu, Ag, Nb, Pd, and Ta. The support member 70 supports the light emitting device according to the embodiment and is electrically connected to an external electrode to supply power to the first light emitting structure 10. The bonding layer 60 may be prepared as a seed layer.

For instance, the support member 70 may comprise at least one selected from the group consisting of Ti, Cr, Ni, Al, Pt, Au, W, Cu, Mo, Cu-W and a semiconductor substrate doped with impurities (i.e., Si, Ge, GaN, GaAs, ZnO, SiC, or SiGe). The support member 70 may comprise an insulating material. For instance, the support member 70 may comprise Al₂O₃ or SiO₂.

Meanwhile, the electrode 80 may be disposed on the first conducive fifth semiconductor layer 31. The electrode 80 may be electrically connected to the first conducive fifth semiconductor layer 31. The electrode 80 may make contact with the top surface of the first conducive fifth semiconductor layer 31.

Therefore, the power may be supplied to the first to third light emitting structures 10, 20 and 30 through the electrode 80 and the first reflective electrode 17. The first to third light emitting structures 10, 20 and 30 are connected with each other in series. Thus, as the power is applied through the electrode 80 and the first reflective electrode 17, the first to third light emitting structures 10, 20 and 30 may emit the light.

According to the embodiment, the electrode 80 may have a multi-layer structure. For instance, the electrode 80 may comprise an ohmic contact layer, an intermediate layer and an upper layer. The ohmic contact layer may comprise one selected from the group consisting of Cr, V, W, Ti, and Zn in order to realize the ohmic contact. The intermediate layer may comprise one selected from the group consisting of Ni, Cu and Al. The upper layer may comprise Au.

Light extracting patterns may be formed on the top surfaces of the first to third light emitting structures 10, 20 and 30. In detail, concavo-convex patterns may be formed on the top surfaces of the first to third light emitting structures 10, 20 and 30. Therefore, according to the embodiment, the external light extraction efficiency can be improved.

According to the embodiment, the top surfaces of the first to third light emitting structures 10, 20, and 30 may be formed as an N face. Since the N face represents surface roughness greater than that of a Ga face, the first to third light emitting structures 10, 20, and 30 can represent more improved light extraction efficiency. In addition, an undoped GaN layer may be further disposed between the electrode 80 and the first conductive type fifth semiconductor layer 31. Therefore, the undoped GaN layer serves as a kind of a balance resistor with respect to the electrode 80 in contact with the N face, so that the operating voltage may be varied.

A protective layer may be formed on the first to third light emitting structures 10, 20 and 30. The protective layer may comprise an oxide or a nitride. For instance, the protective layer may comprise a transmissive and insulating material, such as SiO₂, SiOₓ, SiOₓN_{y}, Si₃N₄, or Al₂O₃. The protective layer may be disposed around the first and third light emitting structures 10 and 30.

According to the embodiment, adjacent light emitting structures can be electrically connected with each other in series through the first and second contact parts 43 and 53. In addition, since an additional insulating layer is not provided between the first and second light emitting structures 10 and 20, an etching process for an insulating layer is not required when the first contact part 43 is formed. Therefore, when the first contact part 43 is formed, manufacturing stability can be enhanced. In other words, since the process of forming the insulating layer and the etching process for the insulating layer are not required, process stability can be ensured.

The light emitting device according to the embodiment comprises a plurality of light emitting cells. Each light emitting cell may comprise a reflective electrode, a second conductive type semiconductor layer on the reflective electrode, an active layer on the second conductive type semiconductor layer, and a first conductive type semiconductor layer on the active layer. In addition, the light emitting device comprises a contact part that makes contact with the lateral side of the first conductive type semiconductor layer of a first light emitting cell and is electrically connected to the reflective electrode of the second light emitting cell adjacent to the first light emitting cell. The contact part may make contact with the top surface of the first conductive type semiconductor layer of the first light emitting cell and may be electrically connected to the reflective electrode of the second light emitting cell. Insulating layers may be disposed between the contact part and the active layer of the first light emitting cell and between the contact part and the second conductive type semiconductor layer of the first light emitting cell. The insulating layer may be disposed under the first conductive type semiconductor layer of the first light emitting cell. In addition, the light emitting device may comprise an electrode electrically connected to the first conductive type semiconductor layer of the second light emitting cell. Thus, as the power is supplied to the reflective electrode of the first light emitting cell and the electrode connected to the second light emitting cell, the first light emitting cell is electrically connected to the second light emitting cell in series, so that the light can be emitted.

Hereinafter, the method for manufacturing the light emitting device according to the embodiment will be described with reference to FIGS. 2 to 6.

According to the method for manufacturing the light emitting device according to the embodiment, as shown in FIG. 2, a first conductive type semiconductor layer 11a, an active layer 12a, and a second conductive type semiconductor layer 13a are formed on a growth substrate 5. The first conductive type semiconductor layer 11a, the active layer 12a, and the second conductive type semiconductor layer 13a may constitute a light emitting structure 10a.

The growth substrate 5 may comprise at least one of Al₂O₃, SiC, GaAs, GaN, ZnO, Si, GaP, InP, and Ge, but the embodiment is not limited thereto. A buffer layer may be additionally disposed between the first conductive type first semiconductor layer 11 and the growth substrate 5.

For instance, the first conductive type semiconductor layer 11a may be prepared as an n type semiconductor layer doped with an n type dopant as a first conductive type dopant, and the second conductive type semiconductor layer 13a may be prepared as a p type semiconductor layer doped with a p type dopant as a second conductive type dopant. In contrast, the first conductive type semiconductor layer 11a may be prepared as the p type semiconductor layer and the second conductive type semiconductor layer 13a may be prepared as an n type semiconductor layer.

For instance, the first conductive type semiconductor layer 11a may comprise an n type semiconductor layer. The first conductive type semiconductor layer 11a may be prepared by using a semiconductor material having a compositional formula of lnₓAl_{y}Ga_{1-x-y}N (0≤x≤1, 0≤y≤1, and 0≤x+y≤1). For instance, the first conductive type first semiconductor layer 11a may comprise one selected from the group consisting of InAIGaN, GaN, AIGaN, AlInN, InGaN, AIN, and InN and may be doped with the n type dopant, such as Si, Ge, Sn, Se, or Te.

The active layer 12a emits the light based on the band gap difference of the energy band according to a material constituting the active layer 12a through the recombination of electrons (or holes) injected through the first conductive type semiconductor layer 11a and holes (or electrons) injected through the second conductive type semiconductor layer 13a. The active layer 12a may have one of a single quantum well structure, a multiple quantum well (MQW) structure, a quantum dot structure, and a quantum wire structure, but the embodiment is not limited thereto.

The active layer 12a may comprise a semiconductor material having a compositional formula of lnₓAl_{y}Ga_{1-x-y}N (0≤x≤1, 0≤y≤1, and 0≤x+y≤1). If the active layer 12a has the MQW structure, the active layer 12a may have a stack structure of a plurality of well layers and a plurality of barrier layers. For example, the active layer 12a may comprise a stack structure of InGaN well/GaN barrier layers.

For instance, the second conductive type semiconductor layer 13a may comprise a p type semiconductor layer. The second conductive type semiconductor layer 13a may be prepared by using a semiconductor material having a compositional formula of lnₓAl_{y}Ga_{1-x-y}N (0≤x≤1, 0≤y≤1, 0≤x+y≤1). For instance, the second conductive type semiconductor layer 13a may comprise one selected from the group consisting of InAIGaN, GaN, AIGaN, InGaN, AlInN, AIN, and InN and may be doped with the p type dopant, such as Mg, Zn, Ca, Sr, or Ba.

Meanwhile, the first conductive type semiconductor layer 11a may comprise a p type semiconductor layer, and the second conductive type semiconductor layer 13a may comprise an n type semiconductor layer. In addition, a semiconductor layer comprising an n type semiconductor layer or a p type semiconductor layer may be formed above the second conductive type semiconductor layer 13a. Accordingly, the light emitting structure 10a may have at least one of NP, PN, NPN, and PNP junction structures. In addition, the doping concentration of impurities in the first conductive type semiconductor layers 11a and the second conductive type semiconductor layer 13a may be uniform or non-uniform. In other words, the light emitting structure 10a may be variously formed, but the embodiment is not limited thereto.

In addition, a first conductive type InGaN/GaN superlattice structure or a first conductive type lnGaN/lnGaN superlattice structure may be formed between the first conductive type semiconductor layers 11a and the active layer 12a. In addition, a second conductive type AIGaN layer may be formed between the second conductive type semiconductor layers 13a and the active layer 12a.

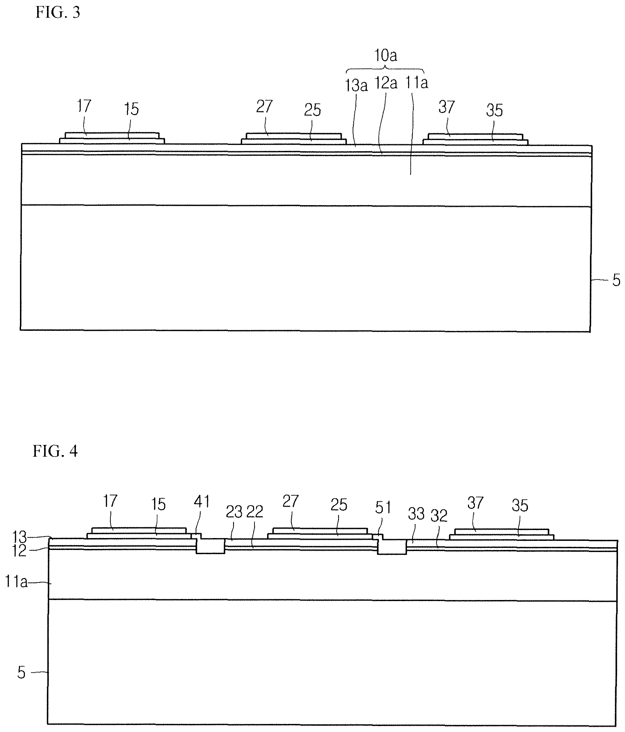

Then, as shown in FIG. 3, the first ohmic contact layer 15 and the first reflective electrode 17 are formed on a first region of the second conductive type semiconductor layer 13a. In addition, the second ohmic contact layer 25 and the second reflective electrode 27 are formed on a second region of the second conductive type semiconductor layer 13a and the third ohmic contact layer 35 and the third reflective electrode 37 are formed on a third region of the second conductive type semiconductor layer 13a.

For instance, the first to third ohmic contact layers 15, 25 and 35 may comprise a transparent conductive oxide layer. In detail, the first to third ohmic contact layers 15, 25 and 35 may comprise at least one selected from the group consisting of ITO, IZO, AZO, AGZO, IZTO, IAZO, IGZO, IGTO, ATO, GZO, IZON, ZnO, IrOx, RuOx, NiO, Pt, and Ag.

The first to third reflective electrodes 17, 27 and 37 may comprise a metallic material having high reflectivity. For instance, the first to third reflective electrodes 17, 27 and 37 may comprise a metal or an alloy comprising at least one selected from the group consisting of Ag Ag, Ni, Al, Rh, Pd, Ir, Ru, Mg, Zn, Pt, Cu, Au, and Hf. In addition, the first to third reflective electrodes 17, 27 and 37 may be formed in a multiple structure by using the metal or the alloy and transmissive conductive material such as ITO, IZO, IZTO, IAZO, IGZO, IGTO, AZO or ATO. For example, according to the embodiment, the first to third reflective electrodes 17, 27 and 37 may comprise at least one of Ag, Al, an Ag-Pd-Cu alloy and an Ag-Cu alloy.

Next, as shown in FIG. 4, the first insulating layer 41 is formed between the second conductive type second semiconductor layer 13 and the second conductive type fourth semiconductor layer 23. The first insulating layer 41 is formed between the first active layer 12 and the second active layer 22. A portion of the first insulating layer 41 may make contact with the first ohmic contact layer 15. The first insulating layer 41 may make contact with the inner part of the first conductive type semiconductor layer 11a. The first insulating layer 41 may comprise a transmissive material or an insulating material. The first insulating layer 41 may comprise a material such as SiO₂, SiOₓ, SiOₓN_{y}, Si₃N₄, Al₂O₃, TiO₂, or AIN.

The second insulating layer 51 is formed between the second conductive type fourth semiconductor layer 23 and the second conductive type sixth semiconductor layer 33. The second insulating layer 51 is formed between the second active layer 22 and the third active layer 33. A portion of the second insulating layer 51 may make contact with the second ohmic contact layer 25. The second insulating layer 51 may make contact with the inner part of the first conductive type semiconductor layer 11a. The second insulating layer 51 may comprise a material such as SiO₂, SiOₓ, SiOₓN_{y}, Si₃N₄, Al₂O₃, TiO₂, or AIN.

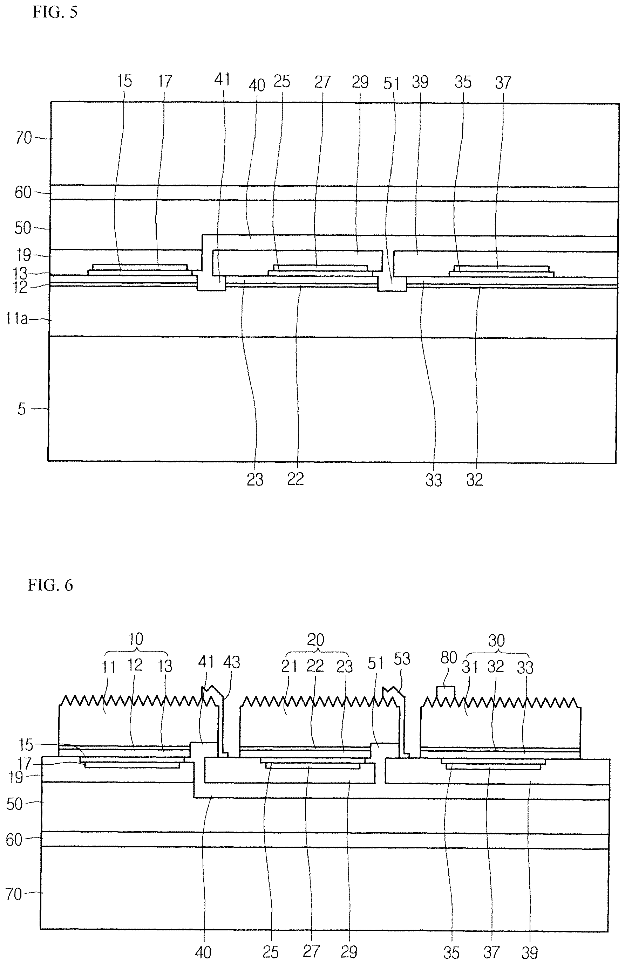

Thereafter, as shown in FIG. 5, the metal layer is formed on the first to third reflective electrodes 17 to 37, and the first and second insulating layers 41 and 51, and then the third insulating layer 40 is formed. The metal layer may be divided into the first to third metal layers 19, 29, and 39 by the third insulating layer 40. The first to third metal layers 19, 29, and 30 are electrically insulated from each other by the third insulating layer 40. The third insulating layer 40 may make contact with the top surface of the first insulating layer 41. The third insulating layer 40 may make contact with the top surface of the second insulating layer 51.

For instance, the first to third metal layers 19 to 39 may comprise at least one of Ni, Ti-W, W, Pt, V, Fe, Mo, Ti, and Cr. In addition, the first to third metal layers 19 to 39 may comprise a transparent conductive oxide layer. The third insulating layer 40 may comprise a transmissive material or an insulating material. For example, the third insulating layer 40 may comprise a material such as SiO₂, SiOₓ, SiOₓN_{y}, Si₃N₄, Al₂O₃, TiO₂, or Al.

The first to third metal layers 19, 29, and 39, and the third insulating layer 40 may be formed through various processes. For instance, the third insulating layer 40 may be formed through a plurality of processes. In addition, the first to third metal layers 19, 29, and 39 may be formed through individual processes.

Next, the diffusion barrier layer 50, the bonding layer 60, and the support member 70 are formed on the first metal layer 19 and the third insulating layer 40 as shown in FIG. 5.

When the bonding layer 60 is formed, the diffusion barrier layer 50 may prevent materials included in the bonding layer 60 from diffusing toward the first reflective electrode 17. In detail, the diffusion barrier layer 50 may prevent the materials included in the bonding layer 60, such as Sn, from exerting an influence upon the first reflective electrode 17. The diffusion barrier layer 50 may comprise at least one of Cu, Ni, Ti-W, W and Pt.

The bonding layer 60 may comprise a barrier metal or a bonding metal. For instance, the bonding layer 60 may comprise at least one of Ti, Au, Sn, Ni, Cr, Ga, In, Bi, Cu, Ag, and Ta. The support member 70 supports the light emitting device according to the embodiment and is electrically connected to an external electrode to supply power to the first reflective electrode 17.

For instance, the support member 70 may comprise at least one selected from the group consisting of Ti, Cr, Ni, Al, Pt, Au, W, Cu, Mo, Cu-W and a semiconductor substrate doped with impurities (i.e., Si, Ge, GaN, GaAs, ZnO, SiC, or SiGe). The support member 70 may comprise an insulating material. For instance, the support member 70 may comprise Al₂O₃ or SiO₂.

Then, the growth substrate 5 is removed from the first conductive type semiconductor layer 11a. For example, the growth substrate 5 can be removed through the laser lift off (LLO) process. According to the LLO process, the laser is irradiated onto the bottom surface of the growth substrate 5 to delaminate the growth substrate 5 from the first conductive type semiconductor layer 11a.

After that, as shown in FIG. 6, an isolation etching process is performed to isolate the first to third light emitting structures 10, 20 and 30 from each other. The isolation etching process may comprise a dry etching process, such as an ICP (inductively coupled plasma) process, but the embodiment is not limited thereto. The first to third metal layers 19, 29 and 39 are partially exposed through the isolation etching process. In addition, a portion of the first insulating layer 41 and a portion of the fifth insulating layer 51 are exposed through the isolation etching process.

Thereafter, as shown in FIG. 6, the first and second contact parts 43 and 53 may be formed. The first contact part 43 may be formed between the first and second light emitting structures 10 and 20. The first contact part 43 electrically connects the first conductive type first semiconductor layer 11 with the second reflective electrode 27. The first contact part 43 makes direct contact with the top surface of the first conductive type first semiconductor layer 11. The first contact part 43 makes direct contact with the lateral side of the first conductive type first semiconductor layer 11. The first contact part 43 makes contact with the second metal layer 29. The first contact part 43 makes direct contact with the top surface of the second metal layer 29. The first contact part 43 may be electrically connected to the second conductive type fourth semiconductor layer 23. The first conductive type first semiconductor layer 11 may be electrically connected to the second conductive type fourth semiconductor layer 23 through the first contact part 43. A portion of the first contact part 43 makes contact with the lateral side of the first insulating layer 41.

For instance, the first contact part 43 may comprise at least one selected from the group consisting of Cr, Al, Ti, Ni, Pt, and V. In addition, the first contact part 43 may comprise a transparent conductive oxide layer. In detail, the first contact part 43 may comprise at least one selected from the group consisting of ITO, IZO, AZO, AGZO, IZTO, IAZO, IGZO, IGTO, ATO, GZO, IZON, ZnO, IrOx, RuOx, and NiO.

The first contact part 43 makes direct contact with the top surface of the first conductive type first semiconductor layer 11. For instance, the first conductive type first semiconductor layer 11 may comprise a GaN layer. When taking the growing direction and etching direction of the semiconductor layer into consideration, the first contact part 43 makes contact with an N face of the first conductive type first semiconductor layer 11.

The first insulating layer 41 is disposed between the first contact part 43 and the second conductive type second semiconductor layer 13. The first insulating layer 41 is disposed between the first contact part 43 and the first active layer 12. The first insulating layer 41 may be disposed at a lower portion of the first conductive type first semiconductor layer 11. The lateral side of the first insulating layer 41 makes contact with the first contact part 43.

The second contact part 53 may be disposed between the second and third light emitting structures 20 and 30. The second contact part 53 electrically connects the first conductive type third semiconductor layer 21 with the third reflective electrode 37. The second contact part 53 may make contact with the top surface of the first conductive type third semiconductor layer 21. The second contact part 53 may make contact with the lateral side of the first conductive type third semiconductor layer 21. The second contact part 53 may make contact with the third metal layer 39. The second contact part 53 may make contact with the top surface of the third metal layer 39. The second contact part 53 may be electrically connected to the second conductive type sixth semiconductor layer 33. The first conductive type third semiconductor layer 21 may be electrically connected to the second conductive type sixth semiconductor layer 33 through the second contact part 53. A portion of the second contact part 53 may make contact with the lateral side of the second insulating layer 51.

For instance, the second contact part 53 may comprise at least one selected from the group consisting of Cr, Al, Ti, Ni, Pt, V, and Ag. In addition, the second contact part 53 may comprise a transparent conductive oxide layer. In detail, the second contact part 53 may comprise at least one selected from the group consisting of ITO, IZO, AZO, AGZO, IZTO, IAZO, IGZO, IGTO, ATO, GZO, IZON, ZnO, IrOx, RuOx, and NiO.

The second contact part 53 may make contact with the top surface of the first conductive type third semiconductor layer 21. For instance, the first conductive type third semiconductor layer 21 may comprise a GaN layer. In this case, when taking the growing direction and etching direction of the semiconductor layer into consideration, the first contact part 53 may make contact with an N face of the first conductive type third semiconductor layer 21.

The second insulating layer 51 may be disposed between the second contact part 53 and the second conductive type fourth semiconductor layer 23. The second insulating layer 51 may be disposed between the second contact part 53 and the second active layer 22. The second insulating layer 51 may be disposed at a lower portion of the first conductive type third semiconductor layer 21. The second insulating layer 51 may make contact with the second contact part 53.

A light extraction pattern may be provided on the top surface of the first to third light emitting structures 10 to 30. A concavo-convex pattern may be provided on the top surface of the first to third light emitting structures 10 to 30. Therefore, according to the embodiment, external light extraction effects may be enhanced. According to the embodiment, the top surface of the first to third light emitting structures 10 to 30 may be formed as an N face. Since the N face represents surface roughness greater than that of a Ga face, the first to third light emitting structures 10, 20, and 30 can represent more improved light extraction efficiency.

Meanwhile, the electrode 80 may be disposed on the first conducive fifth semiconductor layer 31. The electrode 80 may be electrically connected to the first conducive fifth semiconductor layer 31. The electrode 80 may make contact with the top surface of the first conducive fifth semiconductor layer 31.

Therefore, the power may be supplied to the first to third light emitting structures 10, 20 and 30 through the electrode 80 and the first reflective electrode 17. The first to third light emitting structures 10, 20 and 30 are connected with each other in series. Thus, as the power is applied through the electrode 80 and the first reflective electrode 17, the first to third light emitting structures 10, 20 and 30 may emit the light.

According to the embodiment, the electrode 80 may have a multi-layer structure. For instance, the electrode 80 may comprise an ohmic contact layer, an intermediate layer and an upper layer. The ohmic contact layer may comprise one selected from the group consisting of Cr, V, W, Ti, and Zn in order to realize the ohmic contact. The intermediate layer may comprise one selected from the group consisting of Ni, Cu and Al. The upper layer may comprise Au.

The protective layer may be formed on the first to third light emitting structures 10, 20 and 30. The protective layer may comprise an oxide or a nitride. For instance, the protective layer may comprise a transmissive and insulating material, such as SiO₂, SiOₓ, SiOₓN_{y}, Si₃N₄, or Al₂O₃. The protective layer may be disposed around the first and third light emitting structures 10 and 30.

According to the embodiment, the adjacent light emitting structures can be electrically connected with each other in series through the first and second contact parts 43 and 53. In addition, since an additional insulating layer is not provided between the first and second light emitting structures 10 and 20, an etching process for an insulating layer is not required when the first contact part 43 is formed. Therefore, when the first contact part 43 is formed, manufacturing stability can be enhanced. In other words, since the process of forming the insulating layer and the etching process for the insulating layer are not required, process stability can be more ensured.

Meanwhile, the processes of forming the above layers are provided for the illustrative purpose, and the process sequence may be variously modified.

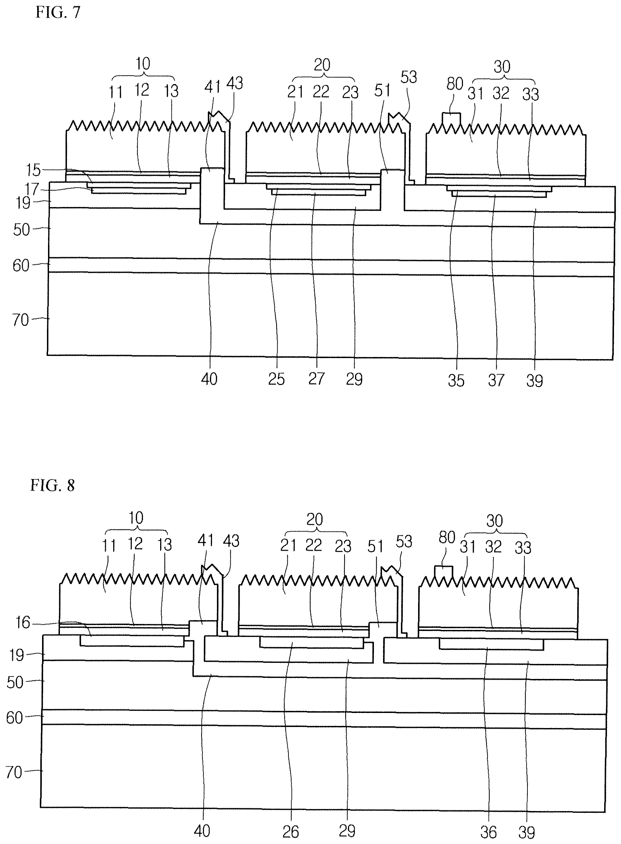

FIG. 7 is a view showing another example of the light emitting device according to the embodiment. When describing the light emitting device according to the embodiment shown in FIG. 7, the structures and the components the same as those of FIG. 1 will not be further described.

The first contact part 43 may be disposed between the first and second light emitting structures 10 and 20. The first contact part 43 electrically connects the first conductive type first semiconductor layer 11 with the second reflective electrode 27. The first contact part 43 makes direct contact with the top surface of the first conductive type first semiconductor layer 11. The first contact part 43 makes direct contact with the lateral side of the first conductive type first semiconductor layer 11. The first contact part 43 may make contact with the second metal layer 29. The first contact part 43 makes direct contact with the top surface of the second metal layer 29. The first contact part 43 may be electrically connected to the second conductive type fourth semiconductor layer 23. The first conductive type first semiconductor layer 11 may be electrically connected to the second conductive type fourth semiconductor layer 23 through the first contact part 43.

For instance, the first contact part 43 may comprise at least one selected from the group consisting of Cr, Al, Ti, Ni, Pt, V, and Ag. In addition, the first contact part 43 may comprise a transparent conductive oxide layer. In detail, the first contact part 43 may comprise at least one selected from the group consisting of ITO, IZO, AZO, AGZO, IZTO, IAZO, IGZO, IGTO, ATO, GZO, IZON, ZnO, IrOx, RuOx, and NiO.

The first contact part 43 makes direct contact with the top surface of the first conductive type first semiconductor layer 11. For instance, the first conductive type first semiconductor layer 11 may comprise a GaN layer. When taking the growing direction and etching direction of the semiconductor layer into consideration, the first contact part 43 may make contact with an N face of the first conductive type first semiconductor layer 11.

The first insulating layer 41 is disposed between the first contact part 43 and the second conductive type second semiconductor layer 13. The first insulating layer 41 is disposed between the first contact part 43 and the first active layer 12. The first insulating layer 41 may be disposed at a lower portion of the first conductive type first semiconductor layer 11. The first insulating layer 41 may make contact with the first contact part 43. The first insulating layer 41 may comprise a transmissive material or an insulating material. For instance, the first insulating layer 41 may comprise SiO₂, SiOₓ, SiOₓN_{y}, Si₃N₄, Al₂O₃, TiO₂, or AlN.

The second contact part 53 may be disposed between the second and third light emitting structures 20 and 30. The second contact part 53 electrically connects the first conductive type third semiconductor layer21 to the third reflective electrode 37. The second contact part 53 may make contact with the top surface of the first conductive type third semiconductor layer 21. The contact part 53 may make contact with the lateral side of the first conductive type third semiconductor layer 21. The second contact part 53 may make contact with the third metal layer 39. The second contact part 53 may make contact with the top surface of the third metal layer 39. The contact part 53 may electrically connected to the second conductive type six semiconductor layer 33. The first conductive type third semiconductor layer 21 may be electrically connected to the second conductive type sixth semiconductor layer 33 through the second contact part 53.

For instance, the second contact part 53 may comprise at least one selected from the group consisting of Cr, Al, Ti, Ni, Pt, V, and Ag. In addition, the second contact part 53 may comprise a transparent conductive oxide layer. In detail, the second contact part 53 may comprise at least one selected from the group consisting of ITO, IZO, AZO, AGZO, IZTO, IAZO, IGZO, IGTO, ATO, GZO, IZON, ZnO, IrOx, RuOx, and NiO.

The second contact part 53 may make contact with the top surface of the first conductive type third semiconductor layer 21. For instance, the first conductive type third semiconductor layer 21 may comprise a GaN layer. In this case, when taking the growing direction and etching direction of the semiconductor layer into consideration, the first contact part 53 may make contact with an N face of the first conductive type third semiconductor layer 21.

The second insulating layer 51 may be disposed between the second contact part 53 and the second conductive type fourth semiconductor layer 23. The second insulating layer 51 may be disposed between the second contact part 53 and the second active layer 22. The second insulating layer 51 may be disposed at a lower portion of the first conductive type third semiconductor layer 21. The second insulating layer 51 may make contact with the second contact part 53. The second insulating layer 51 may comprise a transmissive material, or an insulating material. The second insulating layer 51 may comprise a material such as SiO₂, SiOₓ, SiOₓN_{y}, Si₃N₄, Al₂O₃, TiO₂, or AIN.

The third insulating layer 40 may be disposed between the second metal layer 29 and the third metal layer 39. The third insulating layer 40 may comprise an oxide or a nitride. The third insulating layer 40 may comprise a transmissive and insulating material. For example, the third insulating layer 40 may comprise SiO₂, SiOₓ, SiOₓN_{y}, Si₃N₄, and Al₂O₃. In addition, the third insulating layer 40 may make contact with the lower portion of the first insulating layer 41. In the contact region, the contact area of the top surface of the third insulating layer 40 may be identical to the contact area of the bottom surface of the first insulating layer 41. In addition, the third insulating layer 40 may make contact with the lower portion of the second insulating layer 51. In the contact region, the contact area of the top surface of the third insulating layer 40 may be identical to the contact area of the bottom surface of the second insulating layer 51. A portion of the third insulating layer 40 may be interposed between the first and second metal layers 19 and 29. Another portion of the third insulating layer 40 may be interposed between the second metal layer 29 and the third metal layer 39

FIG. 8 is a view showing still another example of the light emitting device according to the embodiment. When describing the light emitting device according to the embodiment shown in FIG. 8, the structures and the components the same as those of FIG. 1 will not be further described.

According to the light emitting device of the embodiment, a first ohmic reflective electrode 16 may be disposed under the first light emitting structure 10. The first ohmic reflective electrode 16 may be prepared to perform the functions of both of the first reflective electrode 17 and the first ohmic contact layer 15 that have been described with reference to FIG. 1. Thus, the first ohmic reflective electrode 16 makes ohmic-contact with the second conductive type second semiconductor layer 13 and reflects the light incident from the first light emitting structure 10.

In addition, a second ohmic reflective electrode 26 may be disposed under the second light emitting structure 20. The second ohmic reflective electrode 26 may be prepared to perform the functions of both of the second reflective electrode 27 and the second ohmic contact layer 25 that have been described with reference to FIG. 1. Thus, the second ohmic reflective electrode 26 makes ohmic-contact with the second conductive type fourth semiconductor layer 23 and reflects the light incident from the second light emitting structure 20.

Further, a third ohmic reflective electrode 36 may be disposed under the third light emitting structure 30. The third ohmic reflective electrode 36 may be prepared to perform the function of both third reflective electrode 37 and third ohmic contact layer 35 that have been described with reference to FIG. 1. Thus, the third ohmic reflective electrode 36 makes ohmic-contact with the second conductive type sixth semiconductor layer 33 and reflects the light incident from the third light emitting structure 30.

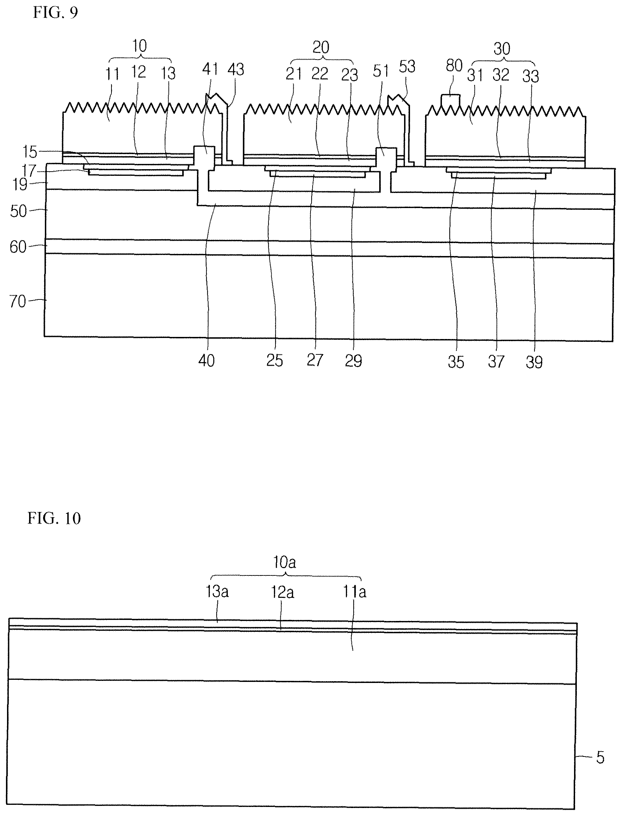

FIG. 9 is a sectional view showing a light emitting device according to the embodiment.

As shown in FIG. 9, the light emitting device according to the embodiment comprises the first to third light emitting structures 10, 20, and 30, and the first to third reflective electrodes 17, 27, and 37, and an electrode 80. Although three light emitting structures are shown in FIG. 9, the light emitting device according to the embodiment may comprise two light emitting structures or at least four light emitting structures.

The light emitting structures may be electrically connected with each other. The light emitting structures may be electrically connected with each other in series. The first and second light emitting structures 10 and 20 may be electrically connected to each other by the first contact part 43. The second and third light emitting structures 20 and 30 may be electrically connected to each other by the second contact part 53. In addition, the light emitting structures may be disposed on the support substrate 70.

The first light emitting structure 10 comprises the first conductive type first semiconductor layer 11, the first active layer 12, and the second conductive type second semiconductor layer 13. The first active layer 12 is disposed between the first conductive type first semiconductor layer 11 and the second conductive type second semiconductor layer 13. The first active layer 12 is disposed under the first conductive type first semiconductor layer 11 and the second conductive type second semiconductor layer 13 is be disposed under the first active layer 12.

For instance, the first conductive type first semiconductor layer 11 may be prepared as an n type semiconductor layer doped with an n type dopant as a first conductive type dopant, and the second conductive type second semiconductor layer 13 may be prepared as a p type semiconductor layer doped with a p type dopant as a second conductive type dopant. In contrast, the first conductive type first semiconductor layer 11 may be prepared as the p type semiconductor layer and the second conductive type second semiconductor layer 13 may be prepared as an n type semiconductor layer.

For instance, the first conductive type first semiconductor layer 11 may comprise an n type semiconductor layer. The first conductive type first semiconductor layer 11 may be prepared as a compound semiconductor. The first conductive type first semiconductor layer 11 may comprise a group II-VI compound semiconductor, or a group III-V compound semiconductor. For example, the first conductive type first semiconductor layer 11 may be prepared by using a semiconductor material having a compositional formula of lnₓAl_{y}Ga_{1-x-y}N (0≤x≤1, 0≤y≤1, and 0≤x+y≤1). For instance, the first conductive type first semiconductor layer 11 may comprise one selected from the group consisting of GaN, AIN, AIGaN, InGaN, InN, InAIGaN, AlInN, AIGaAs, GaP, GaAs, GaAsP, and AlGalnP and may be doped with the n type dopant, such as Si, Ge, Sn, Se, or Te.

The first active layer 12 emits the light based on the band gap difference of the energy band according to a material constituting the first active layer 12 through the recombination of electrons (or holes) injected through the first conductive type first semiconductor layer 11 and holes (or electrons) injected through the second conductive type second semiconductor layer 13. The first active layer 12 may have one of a single quantum well structure, a multiple quantum well (MQW) structure, a quantum dot structure, and a quantum wire structure, but the embodiment is not limited thereto.

The first active layer 12 may comprise a compound semiconductor. The first active layer 12 may comprise a semiconductor material having a compositional formula of lnₓAl_{y}Ga_{1-x-y}N (0≤x≤1, 0≤y≤1, and 0≤x+y≤1). If the first active layer 12 has the MQW structure, the first active layer 12 may have a stack structure of a plurality of well layers and a plurality of barrier layers. For example, the first active layer 12 may comprise a stack structure of InGaN well/GaN barrier layers.

For instance, the second conductive type second semiconductor layer 13 may comprise a p type semiconductor layer. The second conductive type second semiconductor layer 13 may be prepared as a compound semiconductor. The second conductive type second semiconductor layer 13 may comprise a group II-VI compound semiconductor, or a group III-V compound semiconductor. For example, the second conductive type second semiconductor layer 13 may be prepared by using a semiconductor material having a compositional formula of lnₓAl_{y}Ga_{1-x-y}N (0≤x≤1, 0≤y≤1, and 0≤x+y≤1). For instance, the second conductive type second semiconductor layer 13 may comprise one selected from the group consisting of GaN, AIN, AIGaN, InGaN, InN, InAIGaN, AlInN, AIGaAs, GaP, GaAs, GaAsP, and AlGalnP and may be doped with the p type dopant, such as Mg, Zn, Ca, Sr, or Ba.

Meanwhile, the first conductive type first semiconductor layer 11 may comprise a p type semiconductor layer, and the second conductive type second semiconductor layer 13 may comprise an n type semiconductor layer. In addition, a semiconductor layer comprising an n type semiconductor layer or a p type semiconductor layer may be additionally formed under the second conductive type second semiconductor layer 13. Accordingly, the first light emitting structure 10 may have at least one of NP, PN, NPN, and PNP junction structures. In addition, the doping concentration of impurities in the first conductive type first semiconductor layers 11 and the second conductive type second semiconductor layer 13 may be uniform or non-uniform. In other words, the light emitting structure 10 may be variously formed, but the embodiment is not limited thereto.

In addition, a first conductive type InGaN/GaN superlattice structure or a first conductive type lnGaN/lnGaN superlattice structure may be formed between the first conductive type first semiconductor layers 11 and the first active layer 12. In addition, a second conductive type AIGaN layer may be formed between the second conductive type second semiconductor layers 13 and the first active layer 12.

In addition, the second light emitting structure 20 comprises the first conductive type third semiconductor layer 21, the second active layer 22 and the second conductive type fourth semiconductor layer 23. The second active layer 22 is disposed between the first conductive type third semiconductor layer 21 and the second conductive type fourth semiconductor layer 23. The second active layer 22 is disposed under the first conductive type third semiconductor layer 21 and the second conductive type fourth semiconductor layer 23 is disposed under the second active layer 22. The second light emitting structure 20 may be prepared similarly to the first light emitting structure 10 described above.

Further, the third light emitting structure 30 may comprise the first conductive type fifth semiconductor layer 31, the third active layer 32 and the second conductive type sixth semiconductor layer 33. The third active layer 32 may be disposed between the first conductive type fifth semiconductor layer 31 and the second conductive type sixth semiconductor layer 33. The third active layer 32 may be disposed under the first conductive type fifth semiconductor layer 31 and the second conductive type sixth semiconductor layer 33 may be disposed under the third active layer 32. The third light emitting structure 30 may be prepared similarly to the first light emitting structure 10 described above.

The first ohmic contact layer 15 and the first reflective electrode 17 may be disposed under the first light emitting structure 10. The first metal layer 19 may be disposed under the first light emitting structure 10 and around the first reflective electrode 17. The first metal layer 19 may be disposed around the first ohmic contact layer 15 and under the first reflective electrode 17.

For instance, the first ohmic contact layer 15 may comprise a transparent conductive oxide layer. In detail, the first ohmic contact layer 15 may comprise at least one selected from the group consisting of ITO, IZO, AZO, AGZO, IZTO, IAZO, IGZO, IGTO, ATO, GZO, IZON, ZnO, IrOx, RuOx, NiO, Pt, and Ag.

The first reflective electrode 17 may comprise a metallic material having high reflectivity. For instance, the first reflective electrode 17 may comprise a metal or an alloy comprising at least one selected from the group consisting of Ag, Ni, Al, Rh, Pd, Ir, Ru, Mg, Zn, Pt, Au, and Hf. In addition, the first reflective electrode 17 may be formed in a multiple structure by using the metal or the alloy and transmissive conductive material such as ITO, IZO, IZTO, IAZO, IGZO, IGTO, AZO or ATO. For example, according to the embodiment, the first reflective electrode 17 may comprise at least one of Ag, Al, an Ag-Pd-Cu alloy and an Ag-Cu alloy.

The first ohmic contact layer 15 makes ohmic-contact with the first light emitting structure 10. In addition, the first reflective electrode 17 may increase quantity of light extracted to the outside by reflecting the light incident from the first light emitting structure 10.

When the bonding layer 60 is formed, the first metal layer 19 may prevent materials included in the bonding layer 60 from diffusing toward the first reflective electrode 17. In detail, the first metal layer 19 may prevent the materials, such as Sn, included in the bonding layer 60 from exerting an influence on the first reflective electrode 17. The first metal layer 19 may comprise at least one of Cu, Ni, Ti-W, W, Pt, V, Fe, Mo, Ti and Cr. The first metal layer 19 may comprise a transparent conductive oxide layer. The first metal layer 19 may be referred to as an isolation layer or a channel layer.

In addition, the second ohmic contact layer 25 and the second reflective electrode 27 may be disposed under the second light emitting structure 20. The second metal layer 29 may be disposed under the second light emitting structure 20 and around the second reflective electrode 27. The second metal layer 29 may be disposed around the second ohmic contact layer 25 and under the second reflective electrode 27.

For instance, the second ohmic contact layer 25 may comprise the transparent conductive oxide layer. In detail, the second ohmic contact layer 25 may comprise at least one selected from the group consisting of ITO, IZO, AZO, AGZO, IZTO, IAZO, IGZO, IGTO, ATO, GZO, IZON, ZnO, IrOx, RuOx, NiO, Pt, and Ag.

The second reflective electrode 27 may comprise a metallic material having high reflectivity. For instance, the second reflective electrode 27 may comprise a metal or an alloy comprising at least one selected from the group consisting of Ag, Ni, Al, Rh, Pd, Ir, Ru, Mg, Zn, Pt, Cu, Au, and Hf. In addition, the second reflective electrode 27 may be formed in a multiple structure by using the metal or the alloy and transmissive conductive material such as ITO, IZO, IZTO, IAZO, IGZO, IGTO, AZO or ATO. For example, according to the embodiment, the second reflective electrode 27 may comprise at least one of Ag, Al, an Ag-Pd-Cu alloy and an Ag-Cu alloy.

The second ohmic contact layer 25 makes ohmic-contact with the second light emitting structure 20. In addition, the second reflective electrode 27 may increase quantity of light extracted to the outside by reflecting the light incident from the second light emitting structure 20.

When the bonding layer 60 is formed, the second metal layer 29 may prevent materials included in the bonding layer 60 from diffusing toward the second reflective electrode 27. In detail, the second metal layer 29 may prevent the materials included in the bonding layer 60, such as Sn, from exerting an influence upon the second reflective electrode 27. The second metal layer 29 may comprise at least one of Cu, Ni, Ti-W, W, Pt, V, Fe, Mo, Ti and Cr. The second metal layer 29 may comprise a transparent conductive oxide layer.

In addition, the third ohmic contact layer 35 and the third reflective electrode 37 may be disposed under the third light emitting structure 30. The third metal layer 39 may be disposed under the third light emitting structure 30 and around the third reflective electrode 37. The third metal layer 39 may be disposed around the third ohmic contact layer 35 and under the third reflective electrode 37.

For instance, the third ohmic contact layer 35 may comprise a transparent conductive oxide layer. In detail, the third ohmic contact layer 35 may comprise at least one selected from the group consisting of ITO, IZO, AZO, AGZO, IZTO, IAZO, IGZO, IGTO, ATO, GZO, IZON, ZnO, IrOx, RuOx, NiO, Pt, and Ag.

The third reflective electrode 37 may comprise a metallic material having high reflectivity. For instance, the third reflective electrode 37 may comprise a metal or an alloy comprising at least one selected from the group consisting of Ag, Ni, Al, Rh, Pd, Ir, Ru, Mg, Zn, Pt, Cu, Au, and Hf. In addition, the third reflective electrode 37 may be formed in a multiple structure by using the metal or the alloy and transmissive conductive material such as ITO, IZO, IZTO, IAZO, IGZO, IGTO, AZO or ATO. For example, according to the embodiment, the second reflective electrode 37 may comprise at least one of Ag, Al, an Ag-Pd-Cu alloy and an Ag-Cu alloy.

The third ohmic contact layer 35 makes ohmic-contact with the third light emitting structure 30. In addition, the third reflective electrode 37 may increase quantity of light extracted to the outside by reflecting the light incident from the third light emitting structure 30.

When the bonding layer 60 is formed, the third metal layer 39 may prevent materials included in the bonding layer 60 from diffusing toward the third reflective electrode 37. In detail, the third metal layer 39 may prevent the materials, such as Sn, included in the bonding layer 60 from exerting an influence upon the third reflective electrode 37. The third metal layer 39 may comprise at least one of Cu, Ni, Ti-W, W, Pt, V, Fe, Mo, Ti, and Cr.

The first contact part 43 may be disposed between the first light emitting structure 10 and the second light emitting structure 20. The first contact part 43 is electrically connected to the first semiconductor layer 11. The first contact part 43 is electrically connected to the second metal layer 29. The first contact part 43 makes direct contact with the top surface of the first conductive type first semiconductor layer 11. The first contact part 43 makes direct contact with a lateral side of the first conductive type first semiconductor layer 11. The first contact part 43 makes contact with the second metal layer 29. The first contact part 43 makes direct contact with the top surface of the second metal layer 29. Since the second metal layer 29 is electrically connected to the second reflective electrode 27 and the second ohmic contact layer 25, the first contact part 43 may be electrically connected to the second conductive type fourth semiconductor layer 23. Therefore, the first conductive type first semiconductor layer 11 may be electrically connected to the second conductive type fourth semiconductor layer 23 through the first contact part 43.

For instance, the first contact part 43 may comprise at least one selected from the group consisting of Cr, Al, Ti, Ni, Pt, V, and Ag. In addition, the first contact part 43 may comprise a transparent conductive oxide layer. In detail, the first contact part 43 may comprise at least one selected from the group consisting of ITO, IZO, AZO, AGZO, IZTO, IAZO, IGZO, IGTO, ATO, GZO, IZON, ZnO, IrOx, RuOx, and NiO.

The first contact part 43 makes direct contact with the top surface of the first conductive type first semiconductor layer 11. For instance, the first conductive type first semiconductor layer 11 may comprise a GaN layer. When taking the growing direction and etching direction of the semiconductor layer into consideration, the first contact part 43 makes contact with an N face of the first conductive type first semiconductor layer 11.

The first insulating layer 41 is disposed between the first contact part 43 and the second conductive type second semiconductor layer 13. The first insulating layer 41 is disposed between the first contact part 43 and the first active layer 12. The first insulating layer 41 may be disposed at a lower portion of the first conductive type first semiconductor layer 11. The first insulating layer 41 electrically insulates the first contact part 43 from the first active layer 12. The first insulating layer 41 electrically insulates the first contact part 43 and the second semiconductor layer 13.

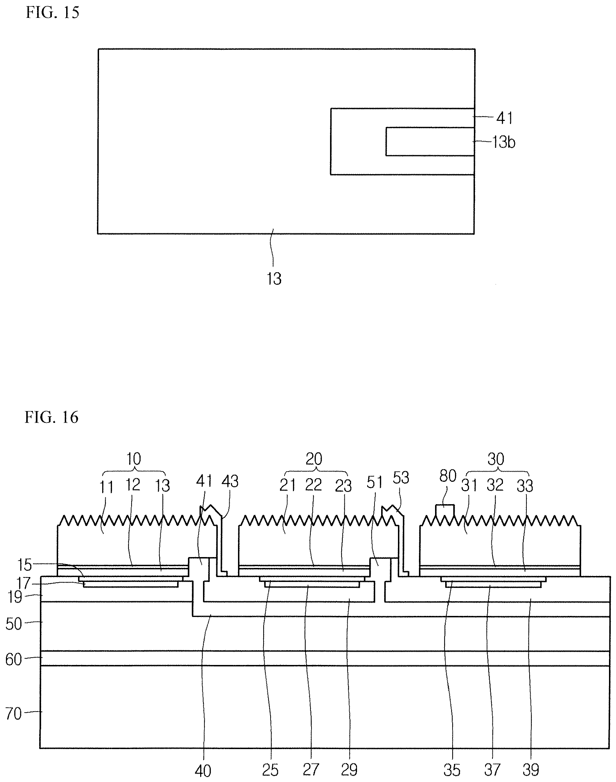

Meanwhile, as shown in FIG. 15, a first region 13b of the second conductive type second semiconductor layer 13 may be isolated by the first insulating layer 41 when viewed from the top. Accordingly, the first region 13b provided at one side of the first insulating layer 41 may be electrically insulated from the second conductive type second semiconductor layer 13 provided at an opposite side of the first insulating layer 41 by the first insulating layer 41. For example, the first contact part 43 may make contact with the first region 13b, and the first contact part 43 may be electrically insulated from the second conductive type second semiconductor layer 13.

Meanwhile, the first region 13b in contact with the first contact part 43 may be electrically insulated from the second conductive type second semiconductor layer 13 in variously modified structures. For example, the first insulating layer 41 may be prepared as a closed loop to surround the central region inside the first light emitting structure 10. The central region of the first light emitting structure 10 is a region to emit light by the first conductive type first semiconductor layer 11, the first active layer 12, and the second conductive type second semiconductor layer 13. Accordingly, the central region of the first light emitting structure 10 may be electrically insulated from an outer peripheral region of the first light emitting structure 10 by the first insulating layer 41. Therefore, the first region 13b making contact with the first contact part 43 may be electrically insulated from the second conductive type second semiconductor layer 13 and the first active layer 12 contributing to the light emission.

The first insulating layer 41 may be provided inside the first semiconductor layer 11 of the first light emitting structure 10. The first contact part 43 may be spaced apart from the first insulating layer 41. The semiconductor layers constituting the first light emitting structure 10 may be partially provided between the first contact part 43 and the first insulating layer 41. The first insulating layer 41 may comprise a material such as SiO₂, SiOₓ, SiOₓN_{y}, Si₃N₄, Al₂O₃, TiO₂, or AIN. In addition, the first insulating layer 41 may be connected to the third insulating layer 40. In other words, the first insulating layer 41 extends from the third insulating layer 40 through the first metal layer 19, the second semiconductor layer 13, and the first active layer 12 to partially make contact with the inner part of the first semiconductor layer 11.

The third insulating layer 40 may electrically insulate the first metal layer 19 from the second metal layer 29.

The second contact part 53 may be disposed between the second and third light emitting structures 20 and 30. The second contact part 53 may be electrically connected to the third semiconductor layer 21. The second contact part 53 may be electrically connected to the third metal layer 39. The second contact part 53 may make contact with the top surface of the first conductive type third semiconductor layer 21. The second contact part 53 may make contact with the lateral side of the first conductive type third semiconductor layer 21. The second contact part 53 may make contact with the third metal layer 39. The second contact part 53 may make contact with the top surface of the third metal layer 39. Since the third metal layer 39 is electrically connected to the third reflective electrode 37 and the third ohmic contact layer 35, the second contact part 53 may be electrically connected to the second conductive type sixth semiconductor layer 33. Therefore, the first conductive type third semiconductor layer 21 may be electrically connected to the second conductive type sixth semiconductor layer 33 through the second contact part 53.

For instance, the second contact part 53 may comprise at least one selected from the group consisting of Cr, Al, Ti, Ni, Pt, V, and Ag. In addition, the second contact part 53 may comprise a transparent conductive oxide layer. In detail, the second contact part 53 may comprise at least one selected from the group consisting of ITO, IZO, AZO, AGZO, IZTO, IAZO, IGZO, IGTO, ATO, GZO, IZON, ZnO, IrOx, RuOx, and NiO.

The second contact part 53 may make contact with the top surface of the first conductive type third semiconductor layer 21. For instance, the first conductive type third semiconductor layer 21 may comprise a GaN layer. In this case, when taking the growing direction and etching direction of the semiconductor layer into consideration, the first contact part 53 may make contact with an N face of the first conductive type third semiconductor layer 21.

The second insulating layer 51 may be disposed between the second contact part 53 and the second conductive type fourth semiconductor layer 23. The second insulating layer 51 may be disposed between the second contact part 53 and the second active layer 22. The second insulating layer 51 may be disposed at a lower portion of the first conductive type third semiconductor layer 21. The second insulating layer 51 may electrically insulate the second contact part 53 from the second active layer 22. The second insulating layer 51 may electrically insulate the second contact part 3 from the fourth semiconductor layer 23.

The second insulating layer 51 may be provided inside the third semiconductor layer 21 of the second light emitting structure 20. The second contact part 53 may be spaced apart from the second insulating layer 51. The semiconductor layers constituting the second light emitting structure 20 may be partially provided between the second contact part 53 and the second insulating layer 51. The second insulating layer 51 may comprise a transmissive material or an insulating material. The second insulating layer 51 may comprise a material such as SiO₂, SiOₓ, SiOₓN_{y}, Si₃N₄, Al₂O₃, TiO₂, or AIN. In addition, the second insulating layer 51 may be connected to the third insulating layer 40. The third insulating layer 40 may electrically insulate the second metal layer 29 from the third metal layer 39.

Meanwhile, referring to FIG. 15, the second insulating layer 51 may have a function and an arrangement similarly to those of the first insulating layer 41. In other words, the first region of the second conductive type fourth semiconductor layer 23 may be isolated by the second insulating layer 51 when viewed from the top.

Accordingly, the first region of the fourth semiconductor layer 23 provided at one side of the second insulating layer 51 may be electrically insulated from the second region of the second conductive type fourth semiconductor layer 23 provided at an opposite side of the second insulating layer 51 by the second insulating layer 51. For example, the second contact part 53 may make contact with the first region, and the second contact part 53 may be electrically insulated from the second conductive type fourth semiconductor layer 23.

Meanwhile, the first region of the fourth semiconductor layer 23 making contact with the second contact part 53 may be electrically insulated from the second region of the fourth semiconductor layer 23 in various modified structures. For example, the second insulating layer 51 may have a closed loop to surround the central region inside the second light emitting structure 20.

In this case, the central region of the second light emitting structure 20 is a region to emit light by the first conductive type third semiconductor layer 21, the second active layer 22, and the second conductive type fourth semiconductor layer 23. Accordingly, the central region of the second light emitting structure 20 may be electrically insulated from an outer peripheral region of the second light emitting structure 20 by the second insulating layer 51. Therefore, the first region 13b making contact with the second contact part 53 may be electrically insulated from the second conductive type fourth semiconductor layer 23 and the second active layer 22 contributing to the light emission.

The third insulating layer 40 may be disposed between the second metal layer 29 and the third metal layer 39. The third insulating layer 40 may comprise an oxide or a nitride. The third insulating layer 40 may comprise a transmissive and insulating material such as SiO₂, SiOₓ, SiOₓN_{y}, Si₃N₄, and Al₂O₃. In addition, the third insulating layer 40 may make contact with the lower portion of the first insulating layer 41. In addition, the third insulating layer 40 may make contact with the lower portion of the second insulating layer 51. The first region of the third insulating layer 40, that is, a region extending to the first insulating layer 41, may be provided between the first metal layer 19 and the second metal layer 29. The second region of the third insulating layer 40, that is, the region extending to the second insulating layer 51 may be provided between the second metal layer 29 and the third metal layer 39.

The diffusion barrier layer 50, the bonding layer 60, and the support member 70 may be disposed under the first metal layer 19 and the third insulating layer 40.

When the bonding layer 60 is formed, the diffusion barrier layer 50 may prevent materials included in the bonding layer 60 from diffusing toward the first to third reflective electrodes 17, 27 and 37. In detail, the diffusion barrier layer 50 may prevent the materials, such as Sn, included in the bonding layer 60 from exerting an influence upon the first to third reflective electrodes 17, 27 and 37. The diffusion barrier layer 50 may comprise at least one of Cu, Ni, Ti-W, W, Pt, V, Fe, and Mo.

The bonding layer 60 may comprise a barrier metal or a bonding metal. For instance, the bonding layer 60 may comprise at least one of Ti, Au, Sn, Ni, Cr, Ga, In, Bi, Cu, Ag, Nb, Pd and Ta. The support member 70 supports the light emitting device according to the embodiment and is electrically connected to an external electrode to supply power to the first light emitting structure 10. The bonding layer 60 may be prepared as a seed layer.

The support member 70 may be provided under the bonding layer 60. The support member 70 may be provided under the first to third light emitting structures 10 to 30. The support member 70 may comprise a conductive material. For instance, the support member 70 may comprise at least one selected from the group consisting of Ti, Cr, Ni, Al, Pt, Au, W, Cu, Mo, Cu-W and a semiconductor substrate doped with impurities (i.e., Si, Ge, GaN, GaAs, ZnO, SiC, or SiGe). The support member 70 may comprise an insulating material. For instance, the support member 70 may comprise Al2O3 or SiO₂.

Meanwhile, the electrode 80 may be disposed on the first conducive fifth semiconductor layer 31. The electrode 80 may be electrically connected to the first conducive fifth semiconductor layer 31. The electrode 80 may make contact with the top surface of the first conducive fifth semiconductor layer 31.

Therefore, the power may be supplied to the first to third light emitting structures 10, 20 and 30 through the electrode 80 and the first reflective electrode 17. The first to third light emitting structures 10, 20 and 30 are electrically connected with each other in series. Thus, as the power is applied through the electrode 80 and the first reflective electrode 17, the first to third light emitting structures 10, 20 and 30 may emit the light.

According to the embodiment, the electrode 80 may have a multi-layer structure. For instance, the electrode 80 may comprise an ohmic contact layer, an intermediate layer and an upper layer. The ohmic contact layer may comprise one selected from the group consisting of Cr, V, W, Ti, and Zn in order to realize the ohmic contact. The intermediate layer may comprise one selected from the group consisting of Ni, Cu and Al. The upper layer may comprise Au.

Light extracting patterns may be formed on the top surfaces of the first to third light emitting structures 10, 20 and 30. In detail, concavo-convex patterns may be formed on the top surfaces of the first to third light emitting structures 10, 20 and 30. Therefore, according to the embodiment, the external light extraction efficiency can be improved.

Meanwhile, when the light extraction pattern is formed on the first to third light emitting structures 10, 20, and 30, a PEC (photo electric chemical) etching process can be used. When the PEC etching process is used, and when the insulating layer exists around the light emitting structures and at a lower portion of the light emitting structure, the etching is performed along an insulating layer in the PEC process. In this case, when the etching is performed along the insulating layer, the semiconductor layers constituting each light emitting structure, especially, each active layer may be damaged. In addition, when the etching process is performed along the insulating layer, delaminating may occur between the light emitting structure and the insulating layer, so that a short phenomenon may occur. Accordingly, electrical reliability may be degraded. However, according to the embodiment, since the insulating layer may not exist around each light emitting structure and at a lower portion of the light emitting structure, even when a PEC etching process is performed, each light emitting structure may not be degraded.

According to the embodiment, the top surface of the first to third light emitting structures 10 to 30 may be formed as an N face. Since the N face represents surface roughness greater than that of a Ga face, the first to third light emitting structures 10, 20, and 30 can represent more improved light extraction efficiency. In addition, an undoped GaN layer may be further disposed between the electrode 80 and the first conductive type fifth semiconductor layer 31. Therefore, the undoped GaN layer serves as a kind of a balance resistor with respect to the electrode 80 in contact with the N face, so that the operating voltage may be varied.

The protective layer may be further formed on the first to third light emitting structures 10, 20 and 30. The protective layer may comprise an oxide or a nitride. For instance, the protective layer may comprise a transmissive and insulating material, such as SiO₂, SiOₓ, SiOₓN_{y}, Si₃N₄, or Al₂O₃. The protective layer may be disposed around the first and third light emitting structures 10 and 30.

According to the embodiment, adjacent light emitting structures can be electrically connected with each other in series through the first and second contact parts 43 and 53. In addition, since an additional insulating layer is not provided between the first and second light emitting structures 10 and 20, an etching process for an insulating layer is not required when the first contact part 43 is formed. Therefore, when the first contact part 43 is formed, manufacturing stability can be enhanced. In other words, since the process of forming the insulating layer and the etching process for the insulating layer are not required, process stability can be relatively ensured.

Meanwhile, as described above, the first and second contact parts 43 and 53 are provided in order to electrically connect the light emitting structures to each other. However, according to the embodiment, the first semiconductor layer 11 of the first light emitting structure 10 may be electrically connected to the fourth semiconductor layer 23 of the second light emitting structure 20 by the second metal layer 29. Accordingly, the first contact part 43 may be selectively removed. In addition, according to the embodiment, the third semiconductor layer 21 of the second light emitting structure 20 may be electrically connected to the sixth semiconductor layer 33 of the third light emitting structure 20 by the third metal layer 39. Therefore, the second contact part 53 may be selectively removed.

The light emitting device according to the embodiment comprises a plurality of light emitting cells. Each light emitting cell may comprise a metal layer, a second conductive type semiconductor layer on the metal layer, an active layer on the second conductive type semiconductor layer, and a first conductive type semiconductor layer on the active layer. In addition, the light emitting device according to the embodiment makes contact with the lateral side of the first conductive type semiconductor layer of a first light emitting cell among the light emitting cells, and a contact part electrically connected to the metal layer of a second light emitting cell adjacent to the first light emitting cell.

In this case, the contact part makes direct contact with the top surface of the first conductive type semiconductor layer of the first light emitting cell, and makes direct contact with the top surface of the metal layer of the second light emitting cell. In addition, according to the light emitting device of the embodiment, an insulating layer is provided between the contact part and the active layer of the first light emitting cell, and between the contact part and the second conductive type semiconductor layer of the first light emitting cell.

The insulating layer electrically insulates the contact part from the active layer of the first light emitting cell. The insulating layer electrically insulates the contact part from the second conductive type semiconductor layer of the first light emitting cell. The insulating layer may electrically insulate the metal layer of the first light emitting cell from the metal layer of the second light emitting cell, and may be partially provided inside the first conductive type semiconductor layer of the first light emitting cell. In addition, the light emitting device may comprise an electrode electrically connected to the first conductive type semiconductor layer of the second light emitting cell. Thus, as the power is supplied to the metal layer of the first light emitting cell and the electrode included in the second light emitting cell, the first light emitting cell is electrically connected to the second light emitting cell in series, so that the light can be emitted.

Hereinafter, a method for manufacturing the light emitting device according to the embodiment will be described with reference to FIGS. 10 to 15.

According to the method for manufacturing the light emitting device according to the embodiment, as shown in FIG. 10, the first conductive type semiconductor layer 11a, the active layer 12a, and the second conductive type semiconductor layer 13a are formed on the growth substrate 5. The first conductive type semiconductor layer 11a, the active layer 12a, and the second conductive type semiconductor layer 13a may constitute the light emitting structure 10a.

The growth substrate 5 may comprise at least one of Al203, SiC, GaAs, GaN, ZnO, Si, GaP, InP, and Ge, but the embodiment is not limited thereto. A buffer layer may be additionally disposed between the first conductive type first semiconductor layer 11 and the growth substrate 5.

For instance, the first conductive type semiconductor layer 11 a may be prepared as an n type semiconductor layer doped with an n type dopant as a first conductive type dopant, and the second conductive type semiconductor layer 13a may be prepared as a p type semiconductor layer doped with a p type dopant as a second conductive type dopant. In contrast, the first conductive type semiconductor layer 11a may be prepared as the p type semiconductor layer and the second conductive type semiconductor layer 13a may be prepared as an n type semiconductor layer.

For instance, the first conductive type semiconductor layer 11a may comprise an n type semiconductor layer. The first conductive type semiconductor layer 11a may be prepared by using a semiconductor material having a compositional formula of lnₓAl_{y}Ga_{1-x-y}N (0≤x≤1, 0≤y≤1, and 0≤x+y≤1). For instance, the first conductive type first semiconductor layer 11a may comprise one selected from the group consisting of InAIGaN, GaN, AIGaN, AlInN, InGaN, AIN, and InN and may be doped with the n type dopant, such as Si, Ge, Sn, Se, or Te.

The active layer 12a emits the light based on the band gap difference of the energy band according to a material constituting the active layer 12a through the recombination of electrons (or holes) injected through the first conductive type semiconductor layer 11a and holes (or electrons) injected through the second conductive type semiconductor layer 13a. The active layer 12a may have one of a single quantum well structure, a multiple quantum well (MQW) structure, a quantum dot structure, and a quantum wire structure, but the embodiment is not limited thereto.

The active layer 12a may comprise a semiconductor material having a compositional formula of lnₓAl_{y}Ga_{1-x-y}N (0≤x≤1, 0≤y≤1, and 0≤x+y≤1). If the active layer 12a has the MQW structure, the active layer 12a may have a stack structure of a plurality of well layers and a plurality of barrier layers. For example, the active layer 12a may comprise a stack structure of InGaN well/GaN barrier layers.

For instance, the second conductive type semiconductor layer 13a may comprise a p type semiconductor layer. The second conductive type semiconductor layer 13a may be prepared by using a semiconductor material having a compositional formula of lnₓAl_{y}Ga_{1-x-y}N (0≤x≤1, 0≤y≤1, 0≤x+y≤1). For instance, the second conductive type semiconductor layer 13a may comprise one selected from the group consisting of InAIGaN, GaN, AIGaN, InGaN, AlInN, AIN, and InN and may be doped with the p type dopant, such as Mg, Zn, Ca, Sr, or Ba.

Meanwhile, the first conductive type semiconductor layer 11a may comprise a p type semiconductor layer, and the second conductive type semiconductor layer 13a may comprise an n type semiconductor layer. In addition, a semiconductor layer comprising an n type semiconductor layer or a p type semiconductor layer may be additionally formed above the second conductive type semiconductor layer 13a. Accordingly, the light emitting structure 10a may have at least one of NP, PN, NPN, and PNP junction structures. In addition, the doping concentration of impurities in the first conductive type semiconductor layers 11a and the second conductive type semiconductor layer 13a may be uniform or non-uniform. In other words, the light emitting structure 10a may be variously formed, but the embodiment is not limited thereto.

In addition, the first conductive type InGaN/GaN superlattice structure or the first conductive type lnGaN/lnGaN superlattice structure may be formed between the first conductive type semiconductor layers 11a and the active layer 12a. In addition, the second conductive type AIGaN layer may be formed between the second conductive type semiconductor layers 13a and the active layer 12a.

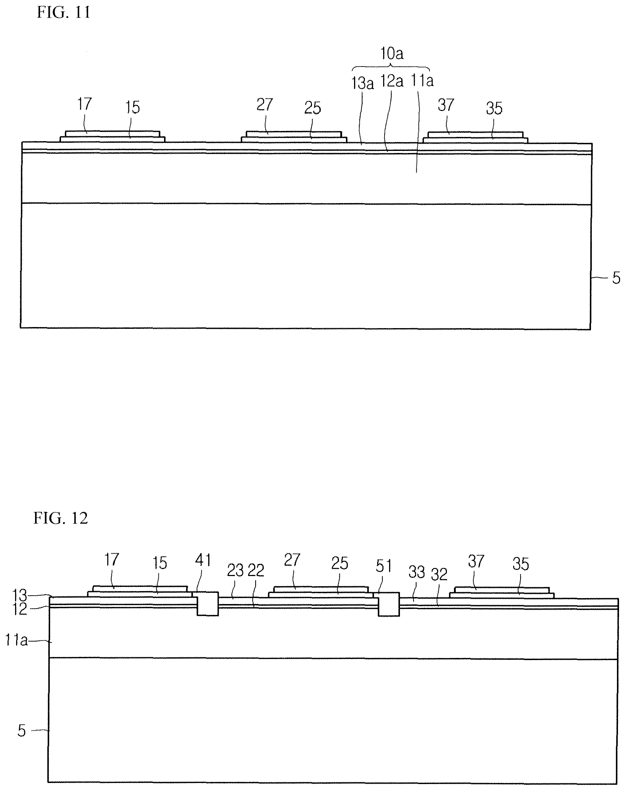

Then, as shown in FIG. 11, the first ohmic contact layer 15 and the first reflective electrode 17 are formed on the first region of the second conductive type semiconductor layer 13a. In addition, the second ohmic contact layer 25 and the second reflective electrode 27 are formed on the second region of the second conductive type semiconductor layer 13a and the third ohmic contact layer 35 and the third reflective electrode 37 are formed on the third region of the second conductive type semiconductor layer 13a.

For instance, the first to third ohmic contact layers 15, 25 and 35 may comprise a transparent conductive oxide layer. In detail, the first to third ohmic contact layers 15, 25 and 35 may comprise at least one selected from the group consisting of ITO, IZO, AZO, AGZO, IZTO, IAZO, IGZO, IGTO, ATO, GZO, IZON, ZnO, IrOx, RuOx, NiO, Pt, and Ag.

The first to third reflective electrodes 17, 27 and 37 may comprise a metallic material having high reflectivity. For instance, the first to third reflective electrodes 17, 27 and 37 may comprise a metal or an alloy comprising at least one selected from the group consisting of Ag, Ni, Al, Rh, Pd, Ir, Ru, Mg, Zn, Pt, Cu, Au, and Hf. In addition, the first to third reflective electrodes 17, 27 and 37 may be formed in a multiple structure by using the metal or the alloy and transmissive conductive material such as ITO, IZO, IZTO, IAZO, IGZO, IGTO, AZO or ATO. For example, according to the embodiment, the first to third reflective electrodes 17, 27 and 37 may comprise at least one of Ag, Al, an Ag-Pd-Cu alloy and an Ag-Cu alloy.

Next, as shown in FIG. 12, the first insulating layer 41 is formed between the second conductive type second semiconductor layer 13 and the second conductive type fourth semiconductor layer 23. The first insulating layer 41 is formed between the first active layer 12 and the second active layer 22. A portion of the first insulating layer 41 may make contact with the first ohmic contact layer 15. The first insulating layer 41 may make contact with the inner part of the first conductive type semiconductor layer 11a. The first insulating layer 41 may comprise a transmissive material or an insulating material. The first insulating layer 41 may comprise a material such as SiO₂, SiOₓ, SiOₓN_{y}, Si₃N₄, Al₂O₃, TiO₂, or AIN.

The second insulating layer 51 is formed between the second conductive type fourth semiconductor layer 23 and the second conductive type sixth semiconductor layer 33. The second insulating layer 51 is formed between the second active layer 22 and the third active layer 33. A portion of the second insulating layer 51 may make contact with the second ohmic contact layer 25. The second insulating layer 51 may make contact with the inner part of the first conductive type semiconductor layer 11a. The second insulating layer 51 may comprise a material such as SiO₂, SiOₓ, SiOₓN_{y}, Si₃N₄, Al₂O₃, TiO₂, or AIN.

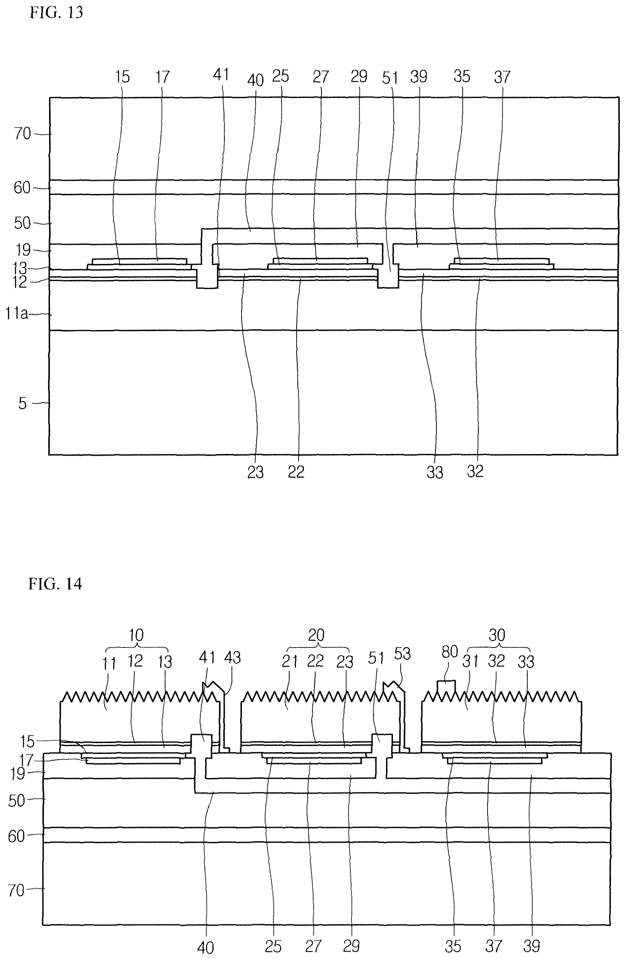

Thereafter, as shown in FIG. 13, the metal layer is formed on the first to third reflective electrodes 17 to 37, and the first and second insulating layers 41 and 51, and then the third insulating layer 40 is formed. The metal layer may be divided into the first to third metal layers 19, 29, and 39 by the third insulating layer 40. The first to third metal layers 19, 29, and 30 are electrically insulated from each other by the third insulating layer 40. The third insulating layer 40 may make contact with the top surface of the first insulating layer 41. The third insulating layer 40 may make contact with the top surface of the second insulating layer 51.

For instance, the first to third metal layers 19 to 39 may comprise at least one of Ni, Ti-W, W, Pt, V, Fe, Mo, Ti, and Cr. In addition, the first to third metal layers 19 to 39 may comprise a transparent conductive oxide layer. The third insulating layer 40 may comprise a transmissive material or an insulating material. For example, the third insulating layer 40 may comprise a material such as SiO₂, SiOₓ, SiOₓN_{y}, Si₃N₄, Al₂O₃, TiO₂, or Al.

The first to third metal layers 19, 29, and 39, and the third insulating layer 40 may be formed through various processes. For instance, the third insulating layer 40 may be formed through a plurality of processes. In addition, the first to third metal layers 19, 29, and 39 may be formed through individual processes.

Next, the diffusion barrier layer 50, the bonding layer 60, and the support member 70 are formed on the first metal layer 19 and the third insulating layer 40 as shown in FIG. 13.

When the bonding layer 60 is formed, the diffusion barrier layer 50 may prevent materials included in the bonding layer 60 from diffusing toward the first reflective electrode 17. In detail, the diffusion barrier layer 50 may prevent the materials included in the bonding layer 60, such as Sn, from exerting an influence upon the first reflective electrode 17. The diffusion barrier layer 50 may comprise at least one of Cu, Ni, Ti-W, W and Pt.

The bonding layer 60 may comprise a barrier metal or a bonding metal. For instance, the bonding layer 60 may comprise at least one of Ti, Au, Sn, Ni, Cr, Ga, In, Bi, Cu, Ag, and Ta. The support member 70 supports the light emitting device according to the embodiment and is electrically connected to an external electrode to supply power to the first reflective electrode 17.

For instance, the support member 70 may comprise at least one selected from the group consisting of Ti, Cr, Ni, Al, Pt, Au, W, Cu, Mo, Cu-W and a semiconductor substrate doped with impurities (i.e., Si, Ge, GaN, GaAs, ZnO, SiC, or SiGe). The support member 70 may comprise an insulating material. For instance, the support member 70 may comprise Al₂O₃ or SiO₂.

Then, the growth substrate 5 is removed from the first conductive type semiconductor layer 11a. For example, the growth substrate 5 can be removed through the laser lift off (LLO) process. According to the LLO process, the laser is irradiated onto the bottom surface of the growth substrate 5 to delaminate the growth substrate 5 from the first conductive type semiconductor layer 11a.

After that, as shown in FIG. 14, an isolation etching process is performed to isolate the first to third light emitting structures 10, 20 and 30 from each other. The isolation etching process may comprise a dry etching process, such as an ICP (inductively coupled plasma) process, but the embodiment is not limited thereto. The first to third metal layers 19, 29 and 39 are partially exposed through the isolation etching process. In addition, the isolation etching process may be performed in such a manner that the first insulating layer 41 and the fifth insulating layer 51 are not exposed to the outside.

Thereafter, as shown in FIG. 14, the first and second contact parts 43 and 53 may be formed. The first contact part 43 may be formed between the first and second light emitting structures 10 and 20. The first contact part 43 electrically connects the first conductive type first semiconductor layer 11 with the second reflective electrode 27. The first contact part 43 may make contact with the top surface of the first conductive type first semiconductor layer 11. The first contact part 43 may make contact with the lateral side of the first conductive type first semiconductor layer 11. The first contact part 43 may make contact with the second metal layer 29. The first contact part 43 may make contact with the top surface of the second metal layer 29. The first contact part 43 may be electrically connected to the second conductive type fourth semiconductor layer 23. The first conductive type first semiconductor layer 11 may be electrically connected to the second conductive type fourth semiconductor layer 23 through the first contact part 43.

For instance, the first contact part 43 may comprise at least one selected from the group consisting of Cr, Al, Ti, Ni, Pt, V, and Ag. In addition, the first contact part 43 may comprise a transparent conductive oxide layer. In detail, the first contact part 43 may comprise at least one selected from the group consisting of ITO, IZO, AZO, AGZO, IZTO, IAZO, IGZO, IGTO, ATO, GZO, IZON, ZnO, IrOx, RuOx, and NiO.

The first contact part 43 may make contact with the top surface of the first conductive type first semiconductor layer 11. For instance, the first conductive type first semiconductor layer 11 may comprise a GaN layer. When taking the growing direction and etching direction of the semiconductor layer into consideration, the first contact part 43 makes contact with an N face of the first conductive type first semiconductor layer 11.

The first insulating layer 41 may be disposed between the first contact part 43 and the second conductive type second semiconductor layer 13. The first insulating layer 41 may be disposed between the first contact part 43 and the first active layer 12. The first insulating layer 41 may be disposed at a lower portion of the first conductive type first semiconductor layer 11.

The second contact part 53 may be disposed between the second and third light emitting structures 20 and 30. The second contact part 53 electrically connects the first conductive type third semiconductor layer 21 to the third reflective electrode 37. The second contact part 53 may make contact with the top surface of the first conductive type third semiconductor layer 21. The second contact part 53 may make contact with the lateral side of the first conductive type third semiconductor layer 21. The second contact part 53 may make contact with the third metal layer 39. The second contact part 53 may make contact with the top surface of the third metal layer 39. The second contact part 53 may be electrically connected to the second conductive type sixth semiconductor layer 33. The first conductive type third semiconductor layer 21 may be electrically connected to the second conductive type sixth semiconductor layer 33 through the second contact part 53.

For instance, the second contact part 53 may comprise at least one selected from the group consisting of Cr, Al, Ti, Ni, Pt, V, and Ag. In addition, the second contact part 53 may comprise a transparent conductive oxide layer. In detail, the second contact part 53 may comprise at least one selected from the group consisting of ITO, IZO, AZO, AGZO, IZTO, IAZO, IGZO, IGTO, ATO, GZO, IZON, ZnO, IrOx, RuOx, and NiO.

The second contact part 53 may make contact with the top surface of the first conductive type third semiconductor layer 21. For instance, the first conductive type third semiconductor layer 21 may comprise a GaN layer. In this case, when taking the growing direction and etching direction of the semiconductor layer into consideration, the first contact part 53 may make contact with an N face of the first conductive type third semiconductor layer 21.

The second insulating layer 51 may be disposed between the second contact part 53 and the second conductive type fourth semiconductor layer 23. The second insulating layer 51 may be disposed between the second contact part 53 and the second active layer 22. The second insulating layer 51 may be disposed at a lower portion of the first conductive type third semiconductor layer 21.

Light extracting patterns may be formed on the top surfaces of the first to third light emitting structures 10, 20 and 30. In detail, concavo-convex patterns may be formed on the top surfaces of the first to third light emitting structures 10, 20 and 30. Therefore, according to the embodiment, external light extraction efficiency can be enhanced. According to the embodiment, the top surface of the first to third light emitting structures 10 to 30 may be formed as an N face. Since the N face represents surface roughness greater than that of a Ga face, the first to third light emitting structures 10, 20, and 30 can represent more improved light extraction efficiency.

Meanwhile, when the light extraction pattern is formed on the first to third light emitting structures 10, 20, and 30, a PEC (photo electric chemical) etching process can be used. When the PEC etching process is used, and when the insulating layer exists around the light emitting structures and at a lower portion of the light emitting structure, the etching is performed along an insulating layer in the PEC process. In this case, when the etching is performed along the insulating layer, the semiconductor layers constituting each light emitting structure, especially, each active layer may be damaged. In addition, when the etching process is performed along the insulating layer, delaminating may occur, so that a short phenomenon may occur. Accordingly, electrical reliability may be degraded. However, according to the embodiment, since the insulating layer may not exist around each light emitting structure and at a lower portion of the light emitting structure, even when a PEC etching process is performed, each light emitting structure may not be degraded.

Meanwhile, the electrode 80 may be disposed on the first conducive fifth semiconductor layer 31. The electrode 80 may be electrically connected to the first conducive fifth semiconductor layer 31. The electrode 80 may make contact with the top surface of the first conducive fifth semiconductor layer 31.

Therefore, the power may be supplied to the first to third light emitting structures 10, 20 and 30 through the electrode 80 and the first reflective electrode 17. The first to third light emitting structures 10, 20 and 30 are connected with each other in series. Thus, as the power is applied through the electrode 80 and the first reflective electrode 17, the first to third light emitting structures 10, 20 and 30 may emit the light.

According to the embodiment, the electrode 80 may have a multi-layer structure. For instance, the electrode 80 may comprise an ohmic contact layer, an intermediate layer and an upper layer. The ohmic contact layer may comprise one selected from the group consisting of Cr, V, W, Ti, and Zn in order to realize the ohmic contact. The intermediate layer may comprise one selected from the group consisting of Ni, Cu and Al. The upper layer may comprise Au.

The protective layer may be formed on the first to third light emitting structures 10, 20 and 30. The protective layer may comprise an oxide or a nitride. For instance, the protective layer may comprise a transmissive and insulating material, such as SiO₂, SiOₓ, SiOₓN_{y}, Si₃N₄, or Al₂O₃. The protective layer may be disposed around the first and third light emitting structures 10 and 30.

According to the embodiment, adjacent light emitting structures can be electrically connected with each other in series through the first and second contact parts 43 and 53. In addition, since an additional insulating layer is not provided between the first and second light emitting structures 10 and 20, an etching process for an insulating layer is not required when the first contact part 43 is formed. Therefore, when the first contact part 43 is formed, manufacturing stability can be enhanced. In other words, since the process of forming the insulating layer and the etching process for the insulating layer are not required, process stability can be ensured.

Meanwhile, the processes of forming the above layers are provided for the illustrative purpose, and the process sequence may be variously modified.

In addition, as shown in FIG. 15, the first region 13b of the second conductive type second semiconductor layer 13 may be isolated by the first insulating layer 41 when viewed from the top. Accordingly, the first region 13b provided at one side of the first insulating layer 41 may be electrically insulated from the second conductive type second semiconductor layer 13 provided at an opposite side of the first insulating layer 41 by the first insulating layer 41. For example, the first contact part 43 may make contact with the first region 13b, and the first contact part 43 may be electrically insulated from the second conductive type second semiconductor layer 13.

Meanwhile, the first region 13b in contact with the first contact part 43 may be electrically insulated from the second conductive type second semiconductor layer 13 in variously modified structures. For example, the first insulating layer 41 may be prepared as a closed loop to surround the central region inside the first light emitting structure 10. The central region of the first light emitting structure 10 is a region to emit light by the first conductive type first semiconductor layer 11, the first active layer 12, and the second conductive type second semiconductor layer 13. Accordingly, the central region of the first light emitting structure 10 may be electrically insulated from an outer peripheral region of the first light emitting structure 10 by the first insulating layer 41. Therefore, the first region 13b making contact with the first contact part 43 may be electrically insulated from the second conductive type second semiconductor layer 13 and the first active layer 12 contributing to the light emission.

FIG. 16 is a sectional view showing another example of the light emitting device according to the embodiment. When describing the light emitting device according to the embodiment shown in FIG. 16, the structures and the components the same as those of FIG. 9 will not be further described.

The first contact part 43 may be disposed between the first light emitting structure 10 and the second light emitting structure 20. The first contact part 43 is electrically connected to the first conductive type first semiconductor layer 11. The first contact part 43 is electrically connected to the second metal layer 29. The first contact part 43 makes direct contact with the top surface of the first conductive type first semiconductor layer 11. The first contact part 43 makes direct contact with a lateral side of the first conductive type first semiconductor layer 11. The first contact part 43 makes contact with the second metal layer 29. The first contact part 43 makes direct contact with the top surface of the second metal layer 29. Since the second metal layer 29 is electrically connected to the second reflective electrode 27 and the second ohmic contact layer 25, the first contact part 43 may be electrically connected to the second conductive type fourth semiconductor layer 23. Therefore, the first conductive type first semiconductor layer 11 may be electrically connected to the second conductive type fourth semiconductor layer 23 through the first contact part 43.

For instance, the first contact part 43 may comprise at least one selected from the group consisting of Cr, Al, Ti, Ni, Pt, V, and Ag. In addition, the first contact part 43 may comprise a transparent conductive oxide layer. In detail, the first contact part 43 may comprise at least one selected from the group consisting of ITO, IZO, AZO, AGZO, IZTO, IAZO, IGZO, IGTO, ATO, GZO, IZON, ZnO, IrOx, RuOx, and NiO.

The first contact part 43 may make contact with the top surface of the first conductive type first semiconductor layer 11. For instance, the first conductive type first semiconductor layer 11 may comprise a GaN layer. When taking the growing direction and etching direction of the semiconductor layer into consideration, the first contact part 43 makes contact with an N face of the first conductive type first semiconductor layer 11.

The first insulating layer 41 is disposed between the first contact part 43 and the second conductive type second semiconductor layer 13. The first insulating layer 41 is disposed between the first contact part 43 and the first active layer 12. The first insulating layer 41 may be disposed at a lower portion of the first conductive type first semiconductor layer 11. The first insulating layer 41 electrically insulates the first contact part 43 from the first active layer 12. The first insulating layer 41 electrically insulates the first contact part 43 from the second semiconductor layer 13.

The first insulating layer 41 may be provided inside the first semiconductor layer 11 of the first light emitting structure 10. The first contact part 43 may be spaced apart from the first insulating layer 41. A portion of the second metal layer 29 may be disposed between the first contact part 43 and the first insulating layer 41. A portion of the second metal layer 29 may make contact with the first semiconductor layer 11. A portion of the second metal layer 29 may make contact to the bottom surface of the first semiconductor layer 11.

The first insulating layer 41 may comprise a material such as SiO₂, SiOₓ, SiOₓN_{y}, Si₃N₄, Al₂O₃, TiO₂, or AIN. In addition, the first insulating layer 41 may be connected to the third insulating layer 40. The third insulating layer 40 may electrically insulate the first metal layer 19 from the second metal layer 29.

The second contact part 53 may be disposed between the second and third light emitting structures 20 and 30. The second contact part 53 may be electrically connected to the third semiconductor layer 21. The second contact part 53 may be electrically connected to the third metal layer 39. The second contact part 53 may make contact with the top surface of the first conductive type third semiconductor layer 21. The second contact part 53 may make contact with the lateral side of the first conductive type third semiconductor layer 21. The second contact part 53 may make contact with the third metal layer 39. The second contact part 53 may make contact with the top surface of the third metal layer 39. Since the third metal layer 39 is electrically connected to the third reflective electrode 37 and the third ohmic contact layer 35, the second contact part 53 may be electrically connected to the second conductive type sixth semiconductor layer 33. Therefore, the first conductive type third semiconductor layer 21 may be electrically connected to the second conductive type sixth semiconductor layer 33 through the second contact part 53.

For instance, the second contact part 53 may comprise at least one selected from the group consisting of Cr, Al, Ti, Ni, Pt, V, and Ag. In addition, the second contact part 53 may comprise a transparent conductive oxide layer. In detail, the second contact part 53 may comprise at least one selected from the group consisting of ITO, IZO, AZO, AGZO, IZTO, IAZO, IGZO, IGTO, ATO, GZO, IZON, ZnO, IrOx, RuOx, and NiO.

The second contact part 53 may make contact with the top surface of the first conductive type third semiconductor layer 21. For instance, the first conductive type third semiconductor layer 21 may comprise a GaN layer. In this case, when taking the growing direction and etching direction of the semiconductor layer into consideration, the first contact part 53 may make contact with an N face of the first conductive type third semiconductor layer 21.

The second insulating layer 51 may be disposed between the second contact part 53 and the second conductive type fourth semiconductor layer 23. The second insulating layer 51 may be disposed between the second contact part 53 and the second active layer 22. The second insulating layer 51 may be disposed at a lower portion of the first conductive type third semiconductor layer 21. The second insulating layer 51 may electrically insulate the second contact part 53 from the second active layer 22. The second insulating layer 51 may electrically insulate the second contact part 53 from the fourth semiconductor layer 23.

The second insulating layer 51 may be provided inside the third semiconductor layer 21 of the second light emitting structure 20. The second contact part 53 may be spaced apart from the second insulating layer 51. A portion of the third metal layer 39 may be provided between the second contact part 53 and the second insulating layer 51. The portion of the third metal layer 39 may make contact with the third semiconductor layer 21. The portion of the third metal layer 39 may make contact with the bottom surface of the third semiconductor layer 21.

The second insulating layer 51 may comprise a transmissive material or an insulating material. The second insulating layer 51 may comprise a material such as SiO₂, SiOₓ, SiOₓN_{y}, Si₃N₄, Al₂O₃, TiO₂, or AIN. In addition, the second insulating layer 51 may be connected to the third insulating layer 40. The third insulating layer 40 may electrically insulate the second metal layer 29 from the third metal layer 39.

The third insulating layer 40 may be disposed between the second metal layer 29 and the third metal layer 39. The third insulating layer 40 may comprise an oxide or a nitride. The third insulating layer 40 may comprise a transmissive and insulating material such as SiO₂, SiOₓ, SiOₓN_{y}, Si₃N₄, and Al₂O₃. In addition, the third insulating layer 40 may make contact with the lower portion of the first insulating layer 41. In addition, the third insulating layer 40 may make contact with the lower portion of the second insulating layer 51. The first region of the third insulating layer 40 may be disposed between the first metal layer 19 and the second metal layer 29. The second region of the third insulating layer 40 may be disposed between the second metal layer 29 and the third metal layer 39.

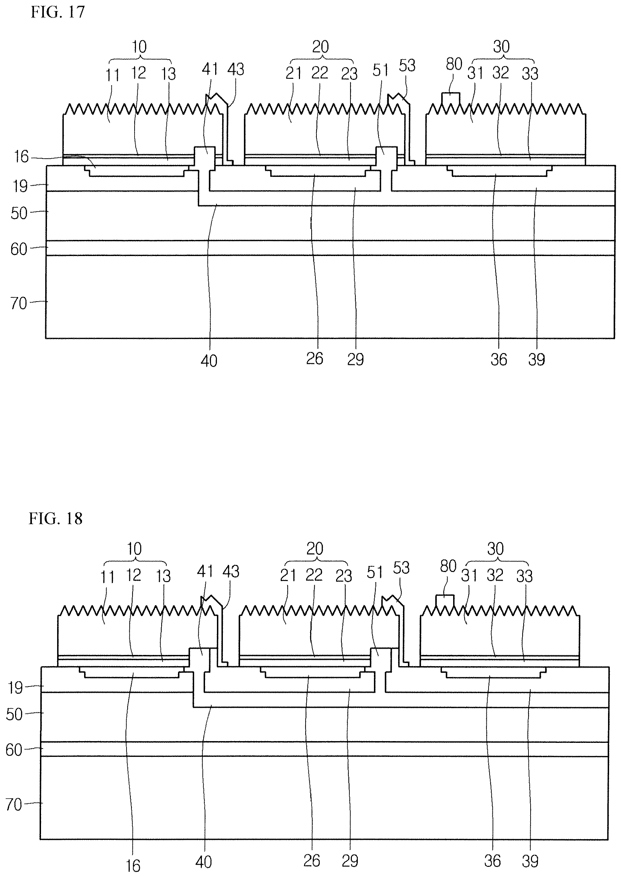

FIG. 17 is a sectional view showing another example of the light emitting device according to the embodiment. When describing the light emitting device according to the embodiment shown in FIG. 17, the structures and the components the same as those of FIG. 9 will not be further described.

According to the light emitting device of the embodiment, a first ohmic reflective electrode 16 may be disposed under the first light emitting structure 10. The first ohmic reflective electrode 16 may be prepared to perform the functions of both of the first reflective electrode 17 and the first ohmic contact layer 15 that have been described with reference to FIG. 1. Thus, the first ohmic reflective electrode 16 makes ohmic-contact with the second conductive type second semiconductor layer 13 and reflects the light incident from the first light emitting structure 10.

In addition, the second ohmic reflective electrode 26 may be disposed under the second light emitting structure 20. The second ohmic reflective electrode 26 may be prepared to perform the functions of both of the second reflective electrode 27 and the second ohmic contact layer 25 that have been described with reference to FIG. 9. Thus, the second ohmic reflective electrode 26 makes ohmic-contact with the second conductive type fourth semiconductor layer 23 and reflects the light incident from the second light emitting structure 20.

Further, the third ohmic reflective electrode 36 may be disposed under the third light emitting structure 30. The third ohmic reflective electrode 36 may be prepared to perform the function of both third reflective electrode 37 and third ohmic contact layer 35 that have been described with reference to FIG. 9. Thus, the third ohmic reflective electrode 36 makes ohmic-contact with the second conductive type sixth semiconductor layer 33 and reflects the light incident from the third light emitting structure 30.

FIG. 18 is a sectional view showing still another example of the light emitting device according to the embodiment. When describing the light emitting device according to the embodiment shown in FIG. 18, the structures and the components the same as those of FIG. 16 will not be further described.

According to the light emitting device of the embodiment, the first ohmic reflective electrode 16 may be disposed under the first light emitting structure 10. The first ohmic reflective electrode 16 may be prepared to perform the functions of both of the first reflective electrode 17 and the first ohmic contact layer 15 that have been described with reference to FIG. 16. Thus, the first ohmic reflective electrode 16 makes ohmic-contact with the second conductive type second semiconductor layer 13 and reflects the light incident from the first light emitting structure 10.

In addition, the second ohmic reflective electrode 26 may be disposed under the second light emitting structure 20. The second ohmic reflective electrode 26 may be prepared to perform the functions of both of the second reflective electrode 27 and the second ohmic contact layer 25 that have been described with reference to FIG. 16. Thus, the second ohmic reflective electrode 26 makes ohmic-contact with the second conductive type fourth semiconductor layer 23 and reflects the light incident from the second light emitting structure 20.

Further, the third ohmic reflective electrode 36 may be disposed under the third light emitting structure 30. The third ohmic reflective electrode 36 may be prepared to perform the function of both third reflective electrode 37 and third ohmic contact layer 35 that have been described with reference to FIG. 16. Thus, the third ohmic reflective electrode 36 makes ohmic-contact with the second conductive type sixth semiconductor layer 33 and reflects the light incident from the third light emitting structure 30.

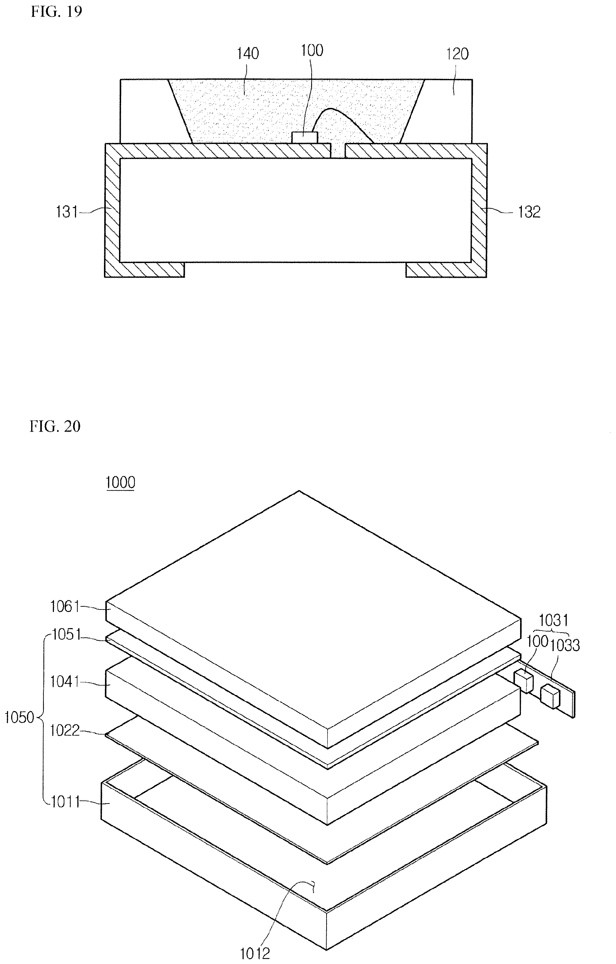

FIG. 19 is a view showing a light emitting device package comprising a light emitting device according to the embodiment.

Referring to FIG. 19, the light emitting device package according to the embodiment comprises a body 120, first and second lead electrodes 131 and 132 formed on the body 120, the light emitting device 100 according to the embodiment, which is installed in the body 120 and electrically connected to the first and second lead electrodes 131 and 132, and a molding member 140 surrounding the light emitting device 100.

The body 120 may comprise silicon, synthetic resin, or metallic material. An inclined surface may be formed around the light emitting device 100.

The first and second lead electrodes 131 and 132 are electrically insulated from each other and supply power to the light emitting device 100. The first and second lead electrodes 131 and 132 may reflect light emitted from the light emitting device 100 to increase light efficiency, and may dissipate heat generated from the light emitting device 100 to the outside.

The light emitting device 100 may be mounted on the body 120 or on the first or second lead electrode 131 or 132.

The light emitting device 100 may be electrically connected with the first and second lead electrode 131 and 132 through one of a wire scheme, a flip chip scheme and a die bonding scheme.

The molding member 140 may protect the light emitting device 100 by surrounding the light emitting device 100. In addition, the molding member 140 may comprise phosphors to change the wavelength of light emitted from the light emitting device 100.

A plurality of light emitting devices according to the embodiment of a plurality of light emitting device packages may be arrayed on the board. In addition, optical members, such as a lens, a light guide plate, a prism sheet and a diffusion sheet, may be installed in an optical path of the light emitting device package. The light emitting device package, the board and the optical members may serve as a light unit. A top view type light unit or a side view type light unit can be provided in a display device of a portable terminal or a notebook computer, or can be applied to various devices such as a lighting device and an indicator. According to another embodiment, there is provided a lighting device comprising the light emitting device or the light emitting device package according to the embodiments. For instance, the lighting device may comprise a lamp, a street lamp, an electric sign board or a headlight.

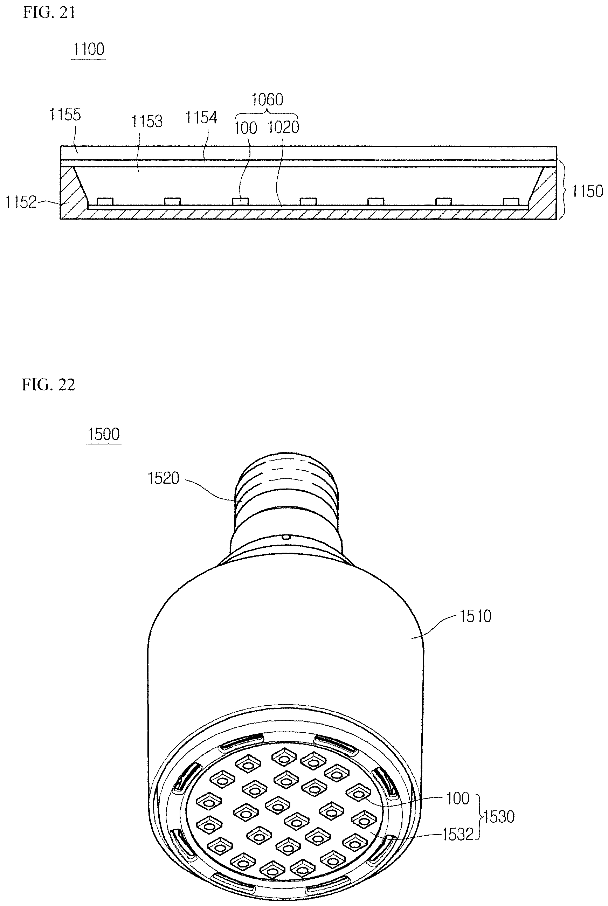

The light emitting device according to the embodiment can be applied to the light unit. The light unit has a structure in which a plurality of light emitting devices are arrayed. The light unit may comprise a display device shown in FIGS. 20 and 21 and a lighting device shown in FIG. 22.

Referring to FIG. 20, the display device 1000 according to the embodiment comprises a light guide plate 1041, a light emitting module 1031 for supplying the light to the light guide plate 1041, a reflective member 1022 under the light guide plate 1041, an optical sheet 1051 on the light guide plate 1041, a display panel 1061 on the optical sheet 1051, and a bottom cover 1011 for receiving the light guide plate 1041, the light emitting module 1031, and the reflective member 1022. However, the embodiment is not limited to the above structure.

The bottom cover 1011, the reflective sheet 1022, the light guide plate 1041 and the optical sheet 1051 may constitute a light unit 1050.

The light guide plate 1041 diffuses the light to provide surface light. The light guide plate 1041 may comprise transparent material. For instance, the light guide plate 1041 may comprise one of acryl-based resin, such as polymethyl methacrylate (PMMA), polyethylene terephthalate (PET), polycarbonate (PC), cyclic olefin copolymer (COC) and polyethylene naphthalate (PEN) resin.

The light emitting module 1031 supplies the light to at least one side of the light guide plate 1041 and serves as the light source of the display device.

At least one light emitting module 1031 is provided to directly or indirectly supply the light from the lateral side of the light guide plate 1041. The light emitting module 1031 may comprise a board 1033 and light emitting devices 100 according to the embodiments. The light emitting devices 100 are arrayed on the board 1033 while being spaced apart from each other at the predetermined interval.

The board 1033 may comprise a printed circuit board (PCB) having a circuit pattern. In addition, the board 1033 may also comprise a metal core PCB (MCPCB) or a flexible PCB (FPCB) as well as a typical PCB, but the embodiment is not limited thereto. If the light emitting devices 100 are installed on the lateral side of the bottom cover 1011 or on a heat dissipation plate, the board 1033 may be omitted. The heat dissipation plate partially makes contact with the top surface of the bottom cover 1011.

In addition, the light emitting devices 100 are arranged such that light exit surfaces of the light emitting devices 100 are spaced apart from the light guide plate 1041 by a predetermined distance, but the embodiment is not limited thereto. The light emitting devices 100 may directly or indirectly supply the light to a light incident surface, which is one side of the light guide plate 1041, but the embodiment is not limited thereto.

The reflective member 1022 is disposed below the light guide plate 1041. The reflective member 1022 reflects the light, which travels downward through the bottom surface of the light guide plate 1041, upward, thereby improving the brightness of the light unit 1050. For instance, the reflective member 1022 may comprise PET, PC or PVC resin, but the embodiment is not limited thereto. The reflective member 1022 may serve as the top surface of the bottom cover 1011, but the embodiment is not limited thereto.

The bottom cover 1011 may receive the light guide plate 1041, the light emitting module 1031, and the reflective member 1022 therein. To this end, the bottom cover 1011 has a receiving section 1012 having a box shape with an open top surface, but the embodiment is not limited thereto. The bottom cover 1011 can be coupled with the top cover, but the embodiment is not limited thereto.

The bottom cover 1011 can be manufactured through a press process or an extrusion process by using metallic material or resin material. In addition, the bottom cover 1011 may comprise metal or non-metallic material having superior thermal conductivity, but the embodiment is not limited thereto.

The display panel 1061, for instance, is an LCD panel comprising transparent first and second substrates, which are opposite to each other, and a liquid crystal layer interposed between the first and second substrates. A polarizing plate can be attached to at least one surface of the display panel 1061, but the embodiment is not limited thereto. The display panel 1061 displays information based on the light that has passed through the optical sheet 1051. The display device 1000 can be applied to various portable terminals, monitors of laptop computers, and televisions.

The optical sheet 1051 is disposed between the display panel 1061 and the light guide plate 1041 and comprises at least one transmissive sheet. For instance, the optical sheet 1051 comprises at least one of a diffusion sheet, a horizontal and vertical prism sheet, and a brightness enhancement sheet. The diffusion sheet diffuses the incident light, the horizontal and vertical prism sheet concentrates the incident light onto the display region, and the brightness enhancement sheet improves the brightness by reusing the lost light. In addition, a protective sheet can be provided on the display panel 1061, but the embodiment is not limited thereto.

The light guide plate 1041 and the optical sheet 1051 can be provided on the optical path of the light emitting module 1031 as optical members, but the embodiment is not limited thereto.

FIG. 21 is a sectional view showing a display device according to another embodiment.

Referring to FIG. 21, the display device 1100 comprises a bottom cover 1152, a board 1020 on which the light emitting devices 100 are arrayed, an optical member 1154, and a display panel 1155.

The board 1020 and the light emitting devices 100 may constitute the light emitting module 1060. In addition, the bottom cover 1152, at least one light emitting module 1060, and the optical member 1154 may constitute the light unit.

The bottom cover 1151 can be provided therein with a receiving section 1153, but the embodiment is not limited thereto.

The optical member 1154 may comprise at least one of a lens, a light guide plate, a diffusion sheet, a horizontal and vertical prism sheet, and a brightness enhancement sheet. The light guide plate may comprise PC or poly methyl methacrylate (PMMA). The light guide plate can be omitted. The diffusion sheet diffuses the incident light, the horizontal and vertical prism sheet concentrates the incident light onto the display region, and the brightness enhancement sheet improves the brightness by reusing the lost light.

The optical member 1154 is disposed above the light emitting module 1060 in order to convert the light emitted from the light emitting module 1060 into the surface light. In addition, the optical member 1154 may diffuse or collect the light.

FIG. 22 is a perspective view showing a lighting device according to the embodiment.

Referring to FIG. 22, the lighting device 1500 comprises a case 1510, a light emitting module 1530 installed in the case 1510, and a connection terminal 1520 installed in the case 1510 to receive power from an external power source.

Preferably, the case 1510 comprises material having superior heat dissipation property. For instance, the case 1510 comprises metallic material or resin material.

The light emitting module 1530 may comprise a board 1532 and light emitting devices 100 according to the embodiment installed on the board 1532. The light emitting devices 100 are spaced apart from each other or arranged in the form of a matrix.

The board 1532 comprises an insulating member printed with a circuit pattern. For instance, the board 1532 comprises a PCB, an MCPCB, an FPCB, a ceramic PCB, and an FR-4 board.

In addition, the board 1532 may comprise material that effectively reflects the light. A coating layer can be formed on the surface of the board 1532. At this time, the coating layer has a white color or a silver color to effectively reflect the light.

At least one light emitting device 100 is installed on the board 1532. Each light emitting device 100 may comprise at least one LED (light emitting diode) chip. The LED chip may comprise an LED that emits the light of visible ray band having red, green, blue or white color and a UV (ultraviolet) LED that emits UV light.

The light emitting devices 100 of the light emitting module 1530 can be variously arranged to provide various colors and brightness. For instance, the white LED, the red LED and the green LED can be arranged to achieve the high color rendering index (CRI).

The connection terminal 1520 is electrically connected to the light emitting module 1530 to supply power to the light emitting module 1530. The connection terminal 1520 has a shape of a socket screw-coupled with the external power source, but the embodiment is not limited thereto. For instance, the connection terminal 1520 can be prepared in the form of a pin inserted into the external power source or connected to the external power source through a wire.

According to the embodiment, the light emitting devices 100 are packaged and then mounted on the board to provide the light emitting module. In addition, the light emitting devices are mounted in the form of the LED chip and then packaged to form the light emitting module.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effects such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the scope of the invention as defined by the claims. More particularly, various variations and modifications are possible in the component parts and/or arrangements of the subject combination arrangement within the scope of the invention as defined by the claims. In addition to variations and modifications in the component parts and/or arrangements, alternative uses will also be apparent to those skilled in the art.

## Claims

1. A light emitting device comprising:
a first light emitting structure (10) comprising a first conductive type first semiconductor layer (11), a first active layer (12) under the first conductive type first semiconductor layer, and a second conductive type second semiconductor layer (13) under the first active layer;
a first metal layer (19) under the first light emitting structure;
a second light emitting structure (20) comprising a first conductive type third semiconductor layer (21), a second active layer (22) under the first conductive type third semiconductor layer, and a second conductive type fourth semiconductor layer (23) under the second active layer;
a second metal layer (29) under the second light emitting structure; and
a contact part (43) electrically connected to the second metal layer (29);
an insulating layer (41) disposed between the contact part (43) and the second conductive type second semiconductor layer (13) of the light emitting region of the first light emitting structure (10), and between the contact part (43) and the first active layer (12) of the light emitting region of the first light emitting structure (10), wherein the insulating layer (41) electrically insulates the contact part (43) from the first active layer (12) of the light emitting region of the first light emitting structure (10) and from the second conductive type second semiconductor layer (13) of the light emitting region of the first light emitting structure (10), and wherein the contact part (43) makes direct contact with a top surface of the first conductive type first semiconductor layer (11), **characterized in that** the insulating layer (41) is disposed in contact with the inner part of the first conductive type first semiconductor layer (11), and the contact part (43) makes direct contact with a lateral side of the first conductive type first semiconductor layer (11) and a top surface of the second metal layer (29).

2. The light emitting device of claim 1, further comprising a first reflective electrode (17) on a part of the first metal layer (19).

3. The light emitting device of claim 1 or 2, further comprising a second reflective electrode (27) on a part of the second metal layer (29).

4. The light emitting device of claim 1, wherein a first region (13b) of the second conductive type second semiconductor layer (13) is electrically insulated from the second conductive type second semiconductor layer of the light emitting region of the first light emitting structure (10) by the first insulating layer (41), and wherein the contact part (43) is contact with the first region (13b).

5. The light emitting device of claim 4, wherein the insulating layer (41) is provided at a lower portion of the first conductive type first semiconductor layer (11).

6. The light emitting device of one of claim 3, further comprising:
a first ohmic contact layer (15) between the first reflective electrode (17) and the second conductive type second semiconductor layer (13); and
a second ohmic contact layer (25) between the second reflective electrode (27) and the second conductive type fourth semiconductor layer (23).

7. The light emitting device of claim 1, wherein the insulating layer (41) electrically insulates the first metal layer (19) from the second metal layer (29).

8. The light emitting device of claim 7, wherein the insulating layer (41) is partially provided inside the first conductive type first semiconductor layer (11) of the first light emitting structure.

9. The light emitting device of claim 7 or 8, wherein the contact part (43) is spaced apart from the insulating layer (41).

10. The light emitting device of one of claims 7 to 9, wherein the semiconductor layers constituting the first light emitting structure (10) are partially provided between the contact part (43) and the insulating layer (41).

11. The light emitting device of one of claims 7 to 9, wherein the second metal layer (29) is partially provided between the contact part (43) and the insulating layer (41).

12. A light emitting device package comprising:
a body (120);
a light emitting device according to one of claims 1 to 11, which is installed on the body; and
first and second lead electrodes (131 and 132) electrically connected to the light emitting device.

13. A light unit comprising:
a board (1020);
a light emitting device according to one of claims 1 to 11, which is installed on the board; and an optical member (1154) passing through a light supplied from the light emitting device.

## Patentansprüche

1. Lichtemittierende Vorrichtung, die aufweist:
eine erste lichtemittierende Struktur (10) mit einer ersten Halbleiterschicht (11) vom ersten Leitungstyp, einer ersten aktiven Schicht (12) unter der ersten Halbleiterschicht vom ersten Leitungstyp, und einer zweiten Halbleiterschicht (13) vom zweiten Leitungstyp unter der ersten aktiven Schicht;
eine erste Metallschicht (19) unter der ersten lichtemittierenden Struktur;
eine zweite lichtemittierende Struktur (20) mit einer dritten Halbleiterschicht (21) vom ersten Leitungstyp, einer zweiten aktiven Schicht (22) unter der dritten Halbleiterschicht vom ersten Leitungstyp, und einer vierten Halbleiterschicht (23) vom zweiten Leitungstyp unter der zweiten aktiven Schicht;
eine zweite Metallschicht (29) unter der zweiten lichtemittierenden Struktur; und
ein Kontaktteil (43), das mit der zweiten Metallschicht (29) elektrisch verbunden ist;
eine Isolierschicht (41), die zwischen dem Kontaktteil (43) und der zweiten Halbleiterschicht (13) vom zweiten Leitungstyp des lichtemittierenden Bereichs der ersten lichtemittierenden Struktur (10) und zwischen dem Kontaktteil (43) und der ersten aktiven Schicht (12) des lichtemittierenden Bereichs der ersten lichtemittierenden Struktur (10) angeordnet ist, wobei die Isolierschicht (41) das Kontaktteil (43) von der ersten aktiven Schicht (12) des lichtemittierenden Bereichs der ersten lichtemittierenden Struktur (10) und von der zweiten Halbleiterschicht (13) vom zweiten Leitungstyp des lichtemittierenden Bereichs der ersten lichtemittierenden Struktur (10) elektrisch isoliert, und wobei das Kontaktteil (43) mit einer oberen Fläche der ersten Halbleiterschicht (11) vom ersten Leitungstyp direkt in Kontakt ist,
**dadurch gekennzeichnet, dass** die Isolierschicht (41) in Kontakt mit dem inneren Teil der ersten Halbleiterschicht (11) vom ersten Leitungstyp angeordnet ist und das Kontaktteil (43) in direktem Kontakt mit einer seitlichen Seite der ersten Halbleiterschicht (11) vom ersten Leitungstyp und einer oberen Fläche der zweiten Metallschicht (29) ist.

2. Lichtemittierende Vorrichtung nach Anspruch 1, die ferner eine erste reflektierende Elektrode (17) auf einem Teil der ersten Metallschicht (19) aufweist.

3. Lichtemittierende Vorrichtung nach Anspruch 1 oder 2, die ferner eine zweite reflektierende Elektrode (27) auf einem Teil der zweiten Metallschicht (29) aufweist.

4. Lichtemittierende Vorrichtung nach Anspruch 1, wobei ein erster Bereich (13b) der zweiten Halbleiterschicht (13) vom zweiten Leitungstyp von der zweiten Halbleiterschicht vom zweiten Leitungstyp des lichtemittierenden Bereichs der ersten lichtemittierenden Struktur (10) durch die erste Isolierschicht (41) elektrisch isoliert ist, und wobei das Kontaktteil (43) mit dem ersten Bereich (13b) in Kontakt ist.

5. Lichtemittierende Vorrichtung nach Anspruch 4, wobei die Isolierschicht (41) an einem unteren Abschnitt der ersten Halbleiterschicht (11) vom ersten Leitungstyp vorgesehen ist.

6. Lichtemittierende Vorrichtung nach Anspruch 3, die ferner aufweist:
eine erste ohmsche Kontaktschicht (15) zwischen der ersten reflektierenden Elektrode (17) und der zweiten Halbleiterschicht (13) vom zweiten Leitungstyp; und
eine zweite ohmsche Kontaktschicht (25) zwischen der zweiten reflektierenden Elektrode (27) und der vierten Halbleiterschicht (23) vom zweiten Leitungstyp.

7. Lichtemittierende Vorrichtung nach Anspruch 1, wobei die Isolierschicht (41) die erste Metallschicht (19) von der zweiten Metallschicht (29) elektrisch isoliert.

8. Lichtemittierende Vorrichtung nach Anspruch 7, wobei die Isolierschicht (41) teilweise innerhalb der ersten Halbleiterschicht (11) vom ersten Leitungstyp der ersten lichtemittierenden Struktur vorgesehen ist.

9. Lichtemittierende Vorrichtung nach Anspruch 7 oder 8, wobei das Kontaktteil (43) von der Isolierschicht (41) beabstandet ist.

10. Lichtemittierende Vorrichtung nach einem der Ansprüche 7 bis 9, wobei die die erste lichtemittierende Struktur (10) bildenden Halbleiterschichten teilweise zwischen dem Kontaktteil (43) und der Isolierschicht (41) vorgesehen sind.

11. Lichtemittierende Vorrichtung nach einem der Ansprüche 7 bis 9, wobei die zweite Metallschicht (29) teilweise zwischen dem Kontaktteil (43) und der Isolierschicht (41) vorgesehen ist.

12. Lichtemittierende Vorrichtungsbaugruppe, die aufweist:
einen Körper (120);
eine lichtemittierende Vorrichtung nach einem der Ansprüche 1 bis 11, die auf dem Körper befestigt ist; und
erste und zweite Leitungselektroden (131 und 132), die mit der lichtemittierenden Vorrichtung elektrisch verbunden sind.

13. Beleuchtungseinheit, die aufweist:
eine Platte (1020);
eine lichtemittierende Vorrichtung nach einem der Ansprüche 1 bis 11, die auf der Platte befestigt ist; und
ein optisches Element (1154), das sich durch ein Licht erstreckt, das von der lichtemittierenden Vorrichtung zugeführt wird.

## Revendications

1. Dispositif luminescent comprenant :
une première structure luminescente (10) comprenant une première couche semi-conductrice d'un premier type de conductivité (11), une première couche active (12) sous la première couche semi-conductrice du premier type de conductivité, et une deuxième couche semi-conductrice d'un deuxième type de conductivité (13) sous la première couche active ;
une première couche métallique (19) sous la première structure luminescente ;
une deuxième structure luminescente (20) comprenant une troisième couche semi-conductrice du premier type de conductivité (21), une deuxième couche active (22) sous la troisième couche semi-conductrice du premier type de conductivité, et une quatrième couche semi-conductrice du deuxième type de conductivité (23) sous la deuxième couche active ;
une deuxième couche métallique (29) sous la deuxième structure luminescente ; et
une partie de contact (43) connectée électriquement à la deuxième couche métallique (29) ;
une couche isolante (41) disposée entre la partie de contact (43) et la deuxième couche semi-conductrice du deuxième type de conductivité (13) de la région luminescente de la première structure luminescente (10), et entre la partie de contact (43) et la première couche active (12) de la région luminescente de la première structure luminescente (10), la couche isolante (41) isolant électriquement la partie de contact (43) de la première couche active (12) de la région luminescente de la première structure luminescente (10) et de la deuxième couche semi-conductrice du deuxième type de conductivité (13) de la région luminescente de la première structure luminescente (10), et la partie de contact (43) faisant un contact direct avec une surface supérieure de la première couche semi-conductrice du premier type de conductivité (11),
**caractérisé en ce que** la couche isolante (41) est disposée en contact avec la partie intérieure de la première couche semi-conductrice du premier type de conductivité (11), et la partie de contact (43) fait un contact direct avec un côté latéral de la première couche semi-conductrice du premier type de conductivité (11) et une surface supérieure de la deuxième couche métallique (29).

2. Dispositif luminescent selon la revendication 1, comprenant en outre une première électrode réfléchissante (17) sur une partie de la première couche métallique (19).

3. Dispositif luminescent selon la revendication 1 ou 2, comprenant en outre une deuxième électrode réfléchissante (27) sur une partie de la deuxième couche métallique (29).

4. Dispositif luminescent selon la revendication 1, dans lequel une première région (13b) de la deuxième couche semi-conductrice du deuxième type de conductivité (13) est électriquement isolée de la deuxième couche semi-conductrice du deuxième type de conductivité de la région luminescente de la première structure luminescente (10) par la première couche isolante (41), et
dans lequel la partie de contact (43) est en contact avec la première région (13b).

5. Dispositif luminescent selon la revendication 4 dans lequel la couche isolante (41) est prévue au niveau d'une portion inférieure de la première couche semi-conductrice du premier type de conductivité (11).

6. Dispositif luminescent selon la revendication 3 comprenant en outre :
une première couche de contact ohmique (15) entre la première électrode réfléchissante (17) et la deuxième couche semi-conductrice du deuxième type de conductivité (13) ; et
une deuxième couche de contact ohmique (25) entre la deuxième électrode réfléchissante (27) et la quatrième couche semi-conductrice du deuxième type de conductivité (23).

7. Dispositif luminescent selon la revendication 1, dans lequel la couche isolante (41) isole électriquement la première couche métallique (19) de la deuxième couche métallique (29).

8. Dispositif luminescent selon la revendication 7 dans lequel la couche isolante (41) est partiellement prévue à l'intérieur de la première couche semi-conductrice du premier type de conductivité (11) de la première structure luminescente.

9. Dispositif luminescent selon la revendication 7 ou 8, dans lequel la partie de contact (43) est espacée de la couche isolante (41).

10. Dispositif luminescent selon l'une des revendications 7 à 9, dans lequel les couches semi-conductrices constituant la première structure luminescente (10) sont partiellement prévues entre la partie de contact (43) et la couche isolante (41).

11. Dispositif luminescent selon l'une des revendications 7 à 9, dans lequel la deuxième couche métallique (29) est partiellement prévue entre la partie de contact (43) et la couche isolante (41).

12. Composant à dispositif luminescent comprenant :
un corps (120) ;
un dispositif luminescent selon l'une des revendications 1 à 11, qui est installé sur le corps ; et
des première et deuxième électrodes conductrices (131 et 132) connectées électriquement au dispositif luminescent.

13. Unité lumineuse comprenant :
une carte (1020) ;
un dispositif luminescent selon l'une des revendications 1 à 11, qui est installé sur la carte ; et un élément optique (1154) laissant passer de la lumière fournie par le dispositif luminescent.
